# EUROPEAN PATENT APPLICATION

(11) **EP 4 654 249 A1**
(43) Date of publication of application: **26.11.2025**
(21) Application number: 24847345.6
(22) Date of filing: 18.04.2024
(51) Int. Cl.: H01L 21/00

(54) **POWER SEMICONDUCTOR STRUCTURE AND MANUFACTURING METHOD THEREFOR**

(30) Priority: 08.04.2024 CN 202410414186
(71) Applicant: Diodes Incorporated, Plano, Texas 75024 (US)
(72) Inventor: CHOU, Li-Hsien, New Taipei City, Taiwan 231023 (TW); HUANG, Pin-Hao, New Taipei City, Taiwan 231023 (TW); LONG, Tao, Shanghai 200063 (CN); HUANG, Cheng-Chin, New Taipei City, Taiwan 231023 (TW)
(74) Representative: Marks & Clerk LLP
(86) International application number: PCT/CN2024/088540
(87) International publication number: WO 2025/213496

(57) **Abstract**

The present application provides a power semiconductor structure and a manufacturing method thereof. The power semiconductor structure includes: a substrate; an epitaxial layer on the substrate; a groove extending into the epitaxial layer; a doped region disposed below the groove; a contact member disposed on the doped region or partially surrounded by the doped region; and a barrier layer disposed on the epitaxial layer and in the groove, where a lateral distance between a sidewall of the groove and an outer sidewall of the contact member and around the contact member is uniform.

## Description

### TECHNICAL FIELD

The present application relates to a power semiconductor structure and a manufacturing method thereof, in particular, to a junction barrier Schottky (JBS) diode and a manufacturing method thereof, and more particularly, to a planar or trench junction barrier Schottky (JBS) diode and a manufacturing method thereof.

### BACKGROUND

A junction barrier Schottky (JBS) diode is a power semiconductor device that combines the characteristics of a Schottky diode and a junction barrier diode. It has the ability to withstand high voltage and provides high voltage component applications. Junction barrier Schottky (JBS) diodes usually have an ohmic contact at the interface between the metal material and the semiconductor material, which realizes low resistance and efficient current flow. Therefore, this ohmic contact is of certain importance to the performance and function of the junction barrier Schottky diodes. Unfortunately, in the manufacturing process of junction barrier Schottky (JBS) diodes, it is difficult to position an ohmic contact at a predetermined position due to the processing limitations at present, and undesirable position misalignment may occur, resulting in leakage and other problems.

Therefore, there is need to improve junction barrier Schottky diodes in the art regarding the leakage problem in order to obtain more ideal high power and low loss.

### SUMMARY

Embodiments of the present disclosure relate to a power semiconductor structure. The power semiconductor structure comprises: a substrate; an epitaxial layer on the substrate; a groove extending into the epitaxial layer; a doped region disposed below the groove; a contact member disposed on the doped region or partially surrounded by the doped region; and a barrier layer disposed on the epitaxial layer and in the groove, wherein a lateral distance that is between a sidewall of the groove and an outer sidewall of the contact member and that is around the contact member is uniform.

An embodiment of the present disclosure relates to a method for manufacturing a power semiconductor structure. The method comprises: forming an epitaxial layer on a substrate; forming an opening extending into the epitaxial layer; implanting an dopant into the epitaxial layer exposed from the opening to form a doped region of the epitaxial layer; filling the opening with a sacrificial member to cover the doped region; disposing a first dielectric layer on the epitaxial layer; removing the sacrificial member from the opening; disposing a second dielectric layer on the first dielectric layer and the doped region, wherein the second dielectric layer is conformal to a sidewall of the opening; removing a first portion of the second dielectric layer to expose a portion of the doped region; disposing a contact material on the portion of the doped region; forming a contact member from the contact material and the portion of the doped region; and removing a remaining portion of the first dielectric layer and the second dielectric layer.

Embodiments of the present disclosure relate to a power semiconductor structure. The power semiconductor structure includes: a substrate; an epitaxial layer on the substrate; a doped region extending into the epitaxial layer; a contact member disposed on the doped region or partially surrounded by the doped region; and a barrier layer disposed on the epitaxial layer and the doped region and surrounding the contact member, wherein a width of an interface between the doped region and the barrier layer and surrounding the contact member is uniform.

Embodiment of the present disclosure relate to a method for manufacturing a power semiconductor structure. The method comprises: forming an epitaxial layer on a substrate; arranging a patterned mask on the epitaxial layer; implanting a dopant into the epitaxial layer exposed from the patterned mask to form a doped region of the epitaxial layer; disposing a sacrificial member to cover the doped region; disposing a first dielectric layer on the epitaxial layer; removing the sacrificial member to form an opening that is surrounded by the first dielectric layer and that exposes the doped region; disposing a second dielectric layer on the first dielectric layer and the doped region, the second dielectric layer conforming to a sidewall of the opening; removing a first portion of the second dielectric layer to expose a portion of the doped region; disposing a contact material on the portion of the doped region; forming a contact member from the contact material and the portion of the doped region; and removing a remaining portion of the first dielectric layer and the second dielectric layer.

### BRIEF DESCRIPTION OF THE DRAWINGS

Aspects of embodiments of the present disclosure may be best understood when the following detailed description is read in conjunction with the accompanying drawings. It should be noted that various structures may not be drawn to scale. In fact, the dimensions of various structures may be enlarged or reduced at will for clarity of discussion.
FIG. 1 is a cross-sectional view of a power semiconductor structure according to some embodiments of the present application;
FIG. 2 is a cross-sectional view of the power semiconductor structure in FIG. 1 along a cutting line AA';
FIG. 3 is a cross-sectional view of a power semiconductor structure according to some other embodiments of the present application;
FIG. 4 is a cross-sectional view of a power semiconductor structure according to some other embodiments of the present application;
FIG. 5 is a cross-sectional view of a power semiconductor structure according to some other embodiments of the present application;
FIGs. 6 to FIG. 26 illustrate one or more stages in a manufacturing method of a power semiconductor structure according to some embodiments of the present application; and
FIGs. 27 to FIG. 46 illustrate one or more stages in a manufacturing method of a power semiconductor structure according to other embodiments of the present disclosure.

The same or similar components are marked with the same reference numerals in the drawings and detailed description. Embodiments of the present disclosure will be readily understood from the following detailed description in conjunction with the accompanying drawings.

### DETAILED DESCRIPTION OF ILLUSTRATIVE EMBODIMENTS

The following disclosure provides many different embodiments or examples for implementing different features of the provided subject matter. Specific examples of components and configurations are described below. Of course, these are only examples and are not intended to be limiting. In the present disclosure, references to forming a first feature above or on a second feature may include embodiments in which the first feature and the second feature are formed to be in direct contact, and may also include embodiments in which additional features may be formed between the first feature and the second feature so that the first feature and the second feature may not be in direct contact. In addition, the present disclosure may repeat reference numerals and/or letters of accompanying drawings in various embodiments. This repetition is for simplicity and clarity and does not itself indicate the relationship between the various embodiments and/or configurations discussed.

The following is a detailed discussion of embodiments of the present disclosure. However, it should be understood that the present disclosure provides many applicable concepts that can be embodied in a variety of specific environments. The specific embodiments discussed are merely illustrative and do not limit the scope of the present disclosure.

The present disclosure provides a power semiconductor structure and a manufacturing method thereof. Compared with forming a contact member on a portion exposed by a patterned mask, the power semiconductor structure of the present disclosure controls the thickness of the patterned mask, and uses the thickness of the patterned mask to define the position of the contact member on a doped region, so that the contact member of the power semiconductor structure of the present disclosure is formed at a specific position on the doped region in a self-alignment manner, and preferably formed at a central position on the doped region, which reduces the reverse leakage current and enables the power semiconductor structure of the present disclosure to withstand a larger surge current in a short period of time without being damaged, so that it can be used in applications of high voltages.

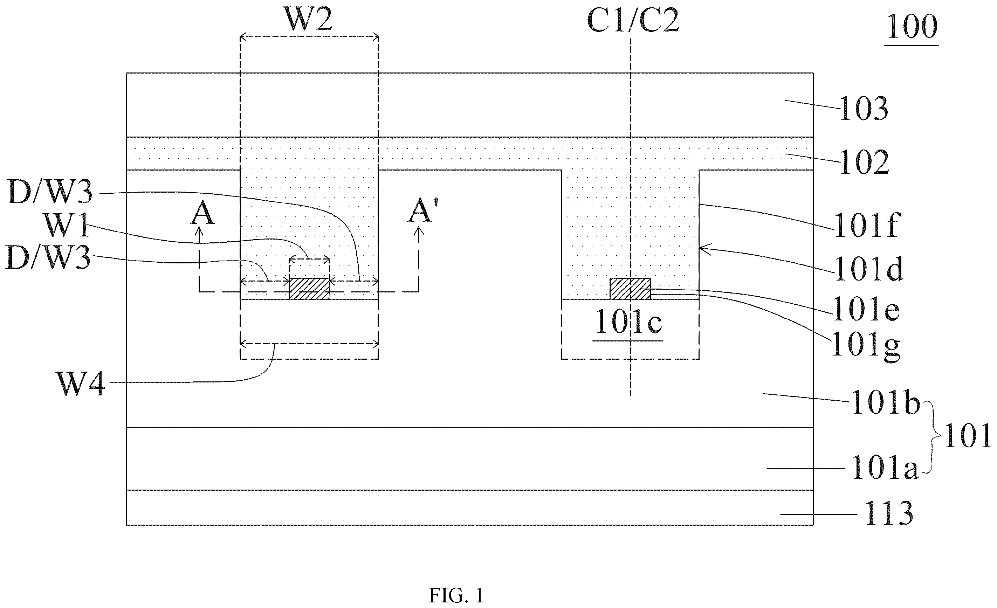

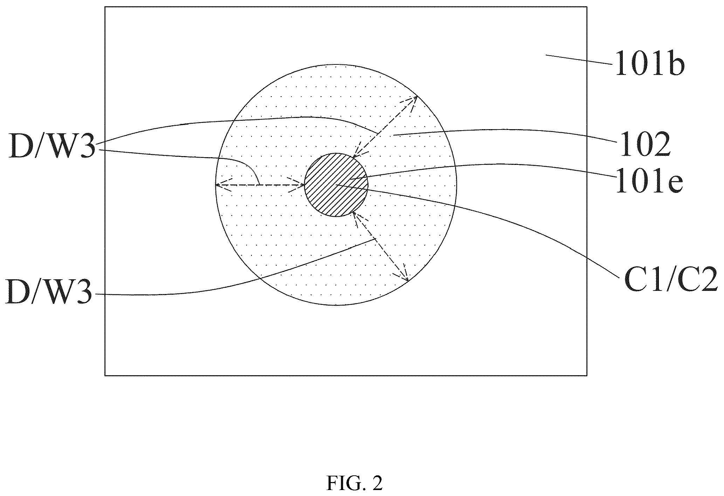

FIG. 1 is a cross-sectional view of a power semiconductor structure 100 according to certain embodiments of the present application, and FIG. 2 is a cross-sectional view of the power semiconductor structure 100 in FIG. 1 along a cutting line AA'. Specifically, the power semiconductor structure 100 is a trench power semiconductor structure. In some embodiments, the power semiconductor structure 100 is a trench junction barrier Schottky (JBS) diode. As shown in FIG. 1, the power semiconductor structure 100 includes a base 101, a barrier layer 102 above the base 101 or partially surrounded by the base 101, and an electrode 103 on the barrier layer 102.

The base 101 includes a substrate 101a and an epitaxial layer 101b on the substrate 101a. In some embodiments, the substrate 101a includes, for example, silicon, silicon carbide (SiC), germanium (Ge), silicon germanium (SiGe), gallium nitride (GaN), gallium arsenide (GaAs), gallium arsenide phosphide (GaAsP), or other semiconductor materials. The epitaxial layer 101b includes, for example, silicon, silicon carbide (SiC), germanium (Ge), silicon germanium (SiGe), gallium nitride (GaN), gallium arsenide (GaAs), gallium arsenide phosphide (GaAsP), or other semiconductor materials. In some embodiments, the substrate 101a and the epitaxial layer 101b both include silicon carbide.

In some embodiments, the substrate 101a is an N-type or P-type semiconductor material, and the epitaxial layer 101b is an N-type or P-type semiconductor material. In some embodiments, the substrate 101a and the epitaxial layer 101b have doping of the same conductivity type, for example, the substrate 101a and the epitaxial layer 101b are both N-type. In some embodiments, the substrate 101a is part of a silicon carbide wafer. In some embodiments, the doping concentration of the substrate 101a is greater than the doping concentration of the epitaxial layer 101b. The substrate 101a and the epitaxial layer 101b both contain a N-type dopant, and the N-type dopant may be, for example, phosphorus (P) or arsenic (As).

In some embodiments, the thickness of the epitaxial layer 101b is greater than the thickness of the substrate 101a. In some embodiments, the thickness of the epitaxial layer 101b is greater than or equal to 6 µm. The thicker the epitaxial layer 101b is, the better the power semiconductor structure 100 is used in applications of high voltages (e.g., 650 volts (V) to 3000 volts).

The base 101 includes groove(s) 101d extending into the epitaxial layer 101b. The groove has a sidewall 101f, and the sidewall 101f extends into the epitaxial layer 101b. Below the groove 101d is a doped region 101c, which is in the epitaxial layer 101b and extends within the epitaxial layer 101b. In some embodiments, the doped region 101c is at the bottom of the groove 101d. The doped region 101c has a conductivity type different from that of the epitaxial layer 101b. In some embodiments, the doped region 101c has a P-type, and the epitaxial layer 101b has an N-type. The doped region 101c contains a P-type dopant, and the P-type dopant may be, for example, boron, aluminum, gallium, indium, etc. In some embodiments, the P-type dopant contained in the doped region 101c is aluminum. The groove 101d has a width W2 and a central axis C2. The doped region 101c has a width W4. In some embodiments, the width W2 of the groove 101d is substantially equal to the width W4 of the doped region 101c. In some embodiments, the central axis C2 of the groove 101d passes through a position approximately halfway of the width W2 of the groove 101d.

The power semiconductor structure 100 includes a contact member 101e disposed on or partially surrounded by the doped region 101c. The contact member 101e is disposed in the groove 101d, partially surrounded by the epitaxial layer 101b, and in contact with the doped region 101c. The contact member 101e has an outer sidewall 101g, a width W1, and a central axis C1. In some embodiments, the central axis C1 of the contact member 101e passes through approximately half of the width W1 of the contact member 101e.

In some embodiments, an ohmic contact is between the contact member 101e and the doped region 101c. The interface between the contact member 101e and the doped region 101c forms the ohmic contact. The contact member 101e includes a semiconductor material and a metal. In some embodiments, the contact member 101e includes the same semiconductor material as the epitaxial layer. In some embodiments, the contact member 101e includes silicide. In some embodiments, the contact member 101e includes nickel (Ni), titanium (Ti), cobalt (Co), platinum (Pt), tantalum (Ta), tungsten (W) or other metals. In some embodiments, the contact member 101e includes nickel silicide (NiSi), titanium silicide (TiSi), cobalt silicide (CoSi), platinum silicide (PtSi), tantalum silicide (TaSi), tungsten silicide (WSi) or other silicide metals.

In some embodiments, there are lateral distances D between the sidewall 101f of the groove 101d and the outer sidewall 101g of the contact member 101e. In some embodiments, the lateral distances D surround the contact member 101e. In some embodiments, the lateral distances D that are between the sidewall 101f of the groove 101d and the outer sidewall 101g of the contact member 101e and that surround the contact member 101e are uniform. In some embodiments, the central axis C2 of the groove 101d is common to the central axis C1 of the contact member 101e. In some embodiments, the width W2 of the groove 101d is substantially equal to twice a lateral distance D plus the width W1 of the contact member 101e. In some embodiments, the lateral distances D are substantially less than or substantially equal to the width W1 of the contact member 101e. In some embodiments, the contact member 101e is disposed at a central position of the groove 101d. In some embodiments, the contact member 101e is disposed at a central position of the surface of the doped region 101c.

The power semiconductor structure 100 includes the barrier layer 102. The barrier layer 102 is disposed on the epitaxial layer 101b and in the groove 101d. The barrier layer 102 at least partially extends to the doped region 101c, the barrier layer 102 surrounds and covers the contact member 101e, and the barrier layer 102 contacts the doped region 101c and the contact member 101e. In some embodiments, the barrier layer 102 contacts the surface of the doped region 101c, the outer sidewall 101g of the contact member 101e, and the sidewall 101f of the groove 101d. In some embodiments, there is a Schottky contact between the barrier layer 102 and the doped region 101c. In some embodiments, the interface between the barrier layer 102 and the epitaxial layer 101b forms a Schottky contact. In some embodiments, the interface between the barrier layer 102 and the doped region 101c forms a Schottky contact. In some embodiments, the sidewall 101f of the groove 101d contacts the barrier layer 102 to form a Schottky contact. The barrier layer 102 includes a metal material or a Schottky metal, such as platinum (Pt), titanium (Ti), nickel (Ni), palladium (Pd), molybdenum (Mo), and so on. The barrier layer 102 is a Schottky barrier.

In some embodiments, a portion of the barrier layer 102 surrounding the contact member 101e has a width W3. In some embodiments, the width W3 of the portion of the barrier layer 102 surrounding the contact member 101e is substantially uniform. In some embodiments, the lateral distances D that are between the sidewall 101f of the groove 101d and the outer sidewall 101g of the contact member 101e and that surround the contact member 101e are substantially equal to the width W3 of the portion of the barrier layer 102 surrounding the contact member 101e. In some embodiments, a ratio of the width W1 of the contact member 101e to the width W3 of the portion of the barrier layer 102 surrounding the contact member 101e is about 1:1 to about 5:1.

The power semiconductor structure 100 further includes the first electrode 103 disposed on the barrier layer 102. In some embodiments, the power semiconductor structure 100 further includes a second electrode 113 disposed below the base 101. In some embodiments, the first electrode 103 and the second electrode 113 are disposed on the upper side and the lower side of the power semiconductor structure 100, respectively. The first electrode 103 covers the barrier layer 102, and the first electrode 103 contacts the barrier layer 102. The second electrode 113 covers and contacts the substrate 101a. The first electrode 103 and the second electrode 113 respectively include conductive materials, e.g., metal materials such as copper (Cu), silver (Ag), gold (Au), and so on.

In some embodiments, the first electrode 103 is an anode or positive electrode, and the second electrode 113 is a cathode or negative electrode. In some embodiments, a current may flow from the first electrode 103 through the barrier layer 102 or the contact member 101e, to the second electrode 113 through the base 101. In some embodiments, a current may flow from the first electrode 103 to the second electrode 113 through the barrier layer 102 and the epitaxial layer 101b. In some embodiments, a current may flow from the first electrode 103 to the second electrode 113 through the barrier layer 102, the contact member 101e, the doped region 101c and the epitaxial layer 101b. In some embodiments, the current flowing from the first electrode 103 to the epitaxial layer 101b through the barrier layer 102 and the contact member 101e is greater than the current flowing from the first electrode 103 to the epitaxial layer 101b through the barrier layer 102.

Since the lateral distances D that are between the sidewall 101f of the groove and the outer sidewall 101g of the contact member 101e and that surround the contact member 101e are uniform, and the contact member 101e is disposed at the center of the surface of the doped region 101c, the reverse leakage current from the first electrode 103 to the second electrode 113 of the power semiconductor structure 100 is reduced or even avoided. Moreover, the power semiconductor structure 100 can withstand a larger current flowing from the first electrode 103 through the barrier layer 102 and the contact member 101e to the epitaxial layer 101b.

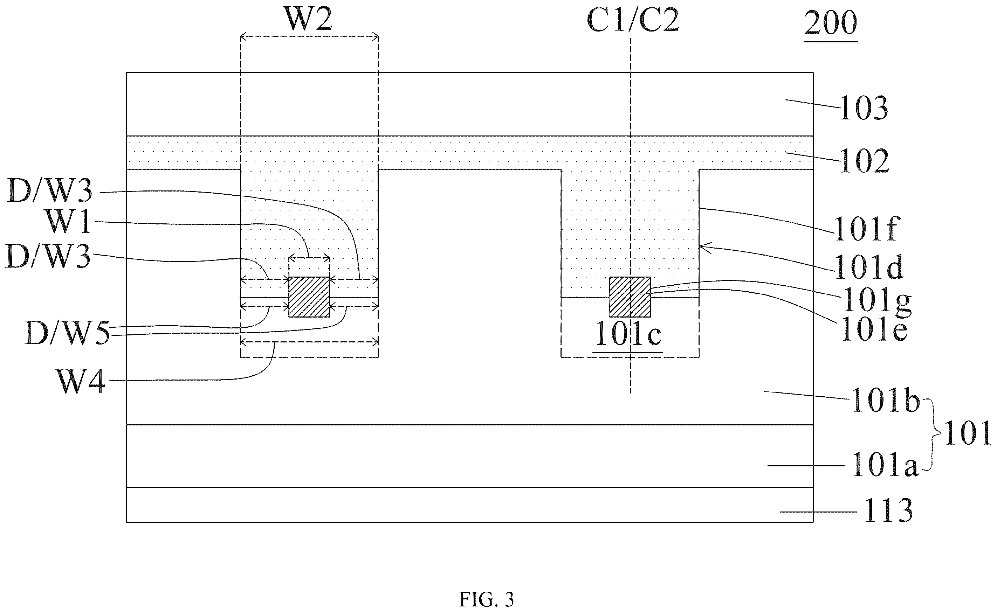

FIG. 3 is a cross-sectional view of another power semiconductor structure 200 according to some embodiments of the present application. Specifically, the power semiconductor structure 200 has a structure similar to the power semiconductor structure 100 shown in FIG. 1, except that a portion of the contact member 101e of the power semiconductor structure 200 is recessed into the epitaxial layer 101b, so that the portion of the contact member 101e is surrounded by the doped region 101c, and another portion of the contact member 101e is surrounded by the barrier layer 102. As shown in FIG. 3, in some embodiments, a portion of the doped region 101c surrounding the contact member 101e has a width W5. In some embodiments, the lateral distances D between the sidewall 101f of the groove 101d and the outer sidewall 101g of the contact member 101e and surrounding the contact member 101e are substantially equal to the width W5 of the portion of the doped region 101c surrounding the contact member 101e. In some embodiments, the width W5 of the portion of the doped region (101c) surrounding the contact member 101e is substantially uniform.

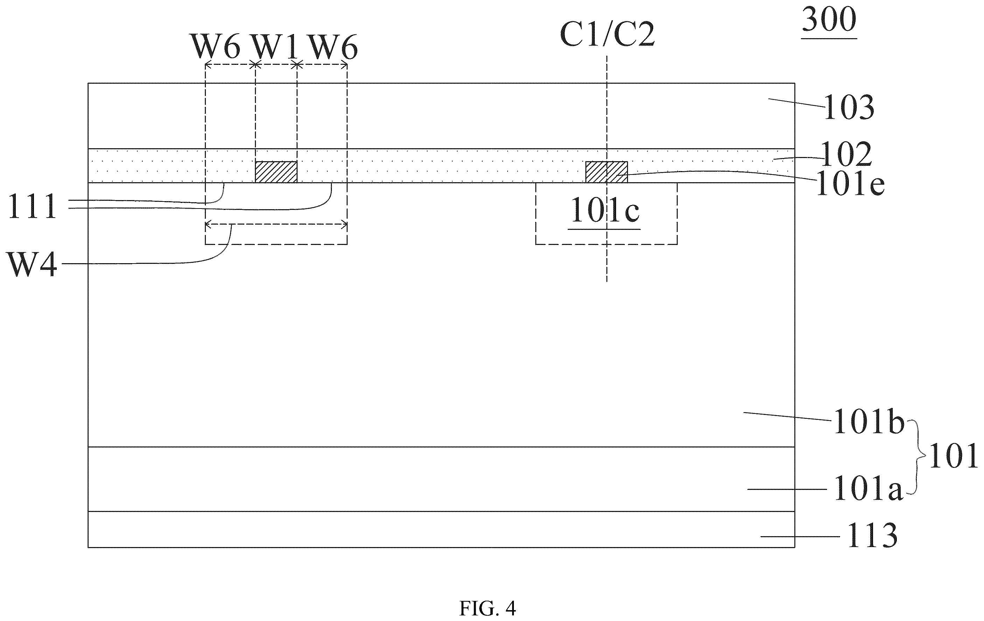

FIG. 4 is a cross-sectional view of yet another power semiconductor structure 300 according to some embodiments of the present application. Specifically, the power semiconductor structure 300 has a similar structure to the power semiconductor structure 100 shown in FIG. 1, except that the power semiconductor structure 300 is a planar power semiconductor structure 300, the power semiconductor structure 300 does not include the groove 101d in the power semiconductor structure 100, and the contact member 101e and the barrier layer 102 of the power semiconductor structure 300 are not in the groove 101d. As shown in FIG. 4, the contact member 101e in the power semiconductor structure 300 is disposed on the doped region 101c. The barrier layer 102 is disposed on the epitaxial layer 101b and the doped region 101c, and covers and surrounds the contact member 101e. In some embodiments, there is an interface 111 between the doped region 101c and the barrier layer 102, and the interface 111 has a width W6. In some embodiments, the width W6 of the interface 111 between the doped region 101c and the barrier layer 102 and surrounding the contact member 101e is uniform. In some embodiments, the width W4 of the doped region 101c is substantially equal to twice the width W6 of the interface 111 plus the width W1 of the contact member 101e. In some embodiments, the ratio of the width W1 of the contact member 101e to the width W6 of the interface 111 surrounding the contact member 101e is about 1:1 to about 5:1.

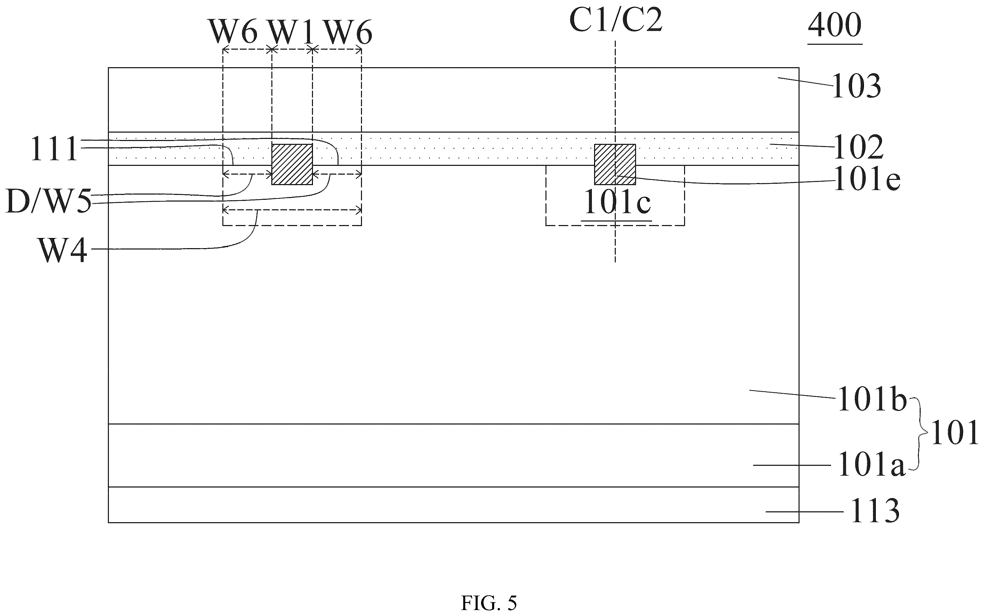

FIG. 5 is a cross-sectional view of yet another power semiconductor structure 400 according to some embodiments of the present application. Specifically, the power semiconductor structure 400 has a similar structure to the power semiconductor structure 200 shown in FIG. 3, except that the power semiconductor structure 400 is a planar power semiconductor structure 400, the power semiconductor structure 400 does not include the groove 101d in the power semiconductor structure 200, and the contact member 101e and the barrier layer 102 of the power semiconductor structure 400 are not in the groove 101d. As shown in FIG. 5, a portion of the contact member 101e of the power semiconductor structure 400 is recessed into the epitaxial layer 101b, so that the portion of the contact member 101e is surrounded by the doped region 101c, and another portion of the contact member 101e is surrounded by the barrier layer 102. In some embodiments, the portion of the doped region 101c surrounding the contact member 101e has the width W5. In some embodiments, the width W5 of the portion of the doped region 101c surrounding the contact member 101e is substantially equal to the width W6 of the interface 111. In some embodiments, the width W5 of the portion of the doped region 101c surrounding the contact member 101e is substantially uniform.

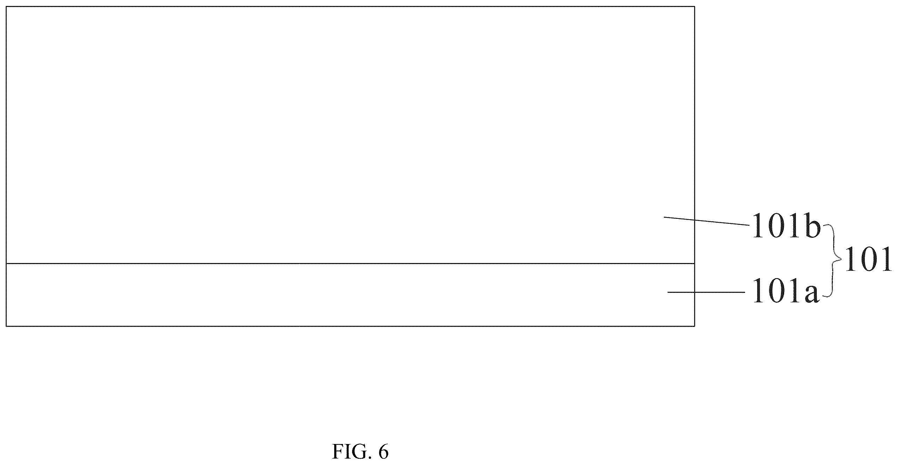

FIG. 6 to FIG. 22 are diagrams illustrating one or more stages in a manufacturing method of the power semiconductor structure 100 according to some embodiments of the present application. At least some of these drawings have been simplified to facilitate a better understanding of aspects of the present disclosure.

Referring to FIG. 6, the manufacturing method includes forming the epitaxial layer 101b on the substrate 101a. The substrate 101a and the epitaxial layer 101b respectively include semiconductor materials such as silicon carbide (SiC). In some embodiments, the substrate 101a is an N-type or P-type semiconductor material. Epitaxial growth is performed on the substrate 101a to form the epitaxial layer 101b. In some embodiments, the epitaxial growth is simultaneously performed with dopant implantation, the implantation has an N-type dopant, and the N-type dopant may be, for example, phosphorus (P) or arsenic (As), to form the epitaxial layer 101b of N-type. In some embodiments, the substrate 101a and the epitaxial layer 101b have the same conductive type doping, for example, the substrate 101a and the epitaxial layer 101b are both N-type. In some embodiments, the doping concentration of the substrate 101a is substantially greater than the doping concentration of the epitaxial layer 101b.

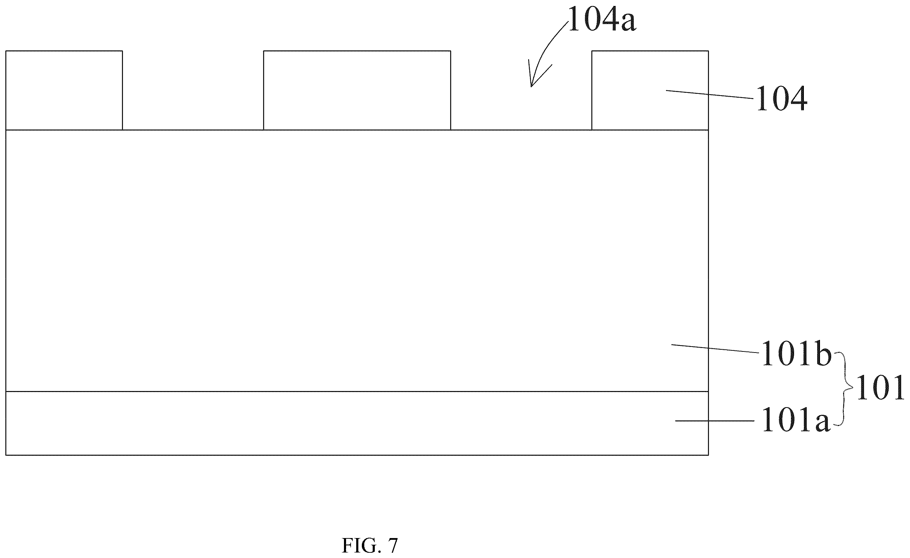

Referring to FIG. 7, in some embodiments, the manufacturing method includes disposing a patterned mask 104 on the epitaxial layer 101b. In some embodiments, the patterned mask 104 includes a photoresist or an oxide, or others. The patterned mask 104 has opening(s) 104a, and the epitaxial layer 101b is at least partially exposed from the patterned mask 104.

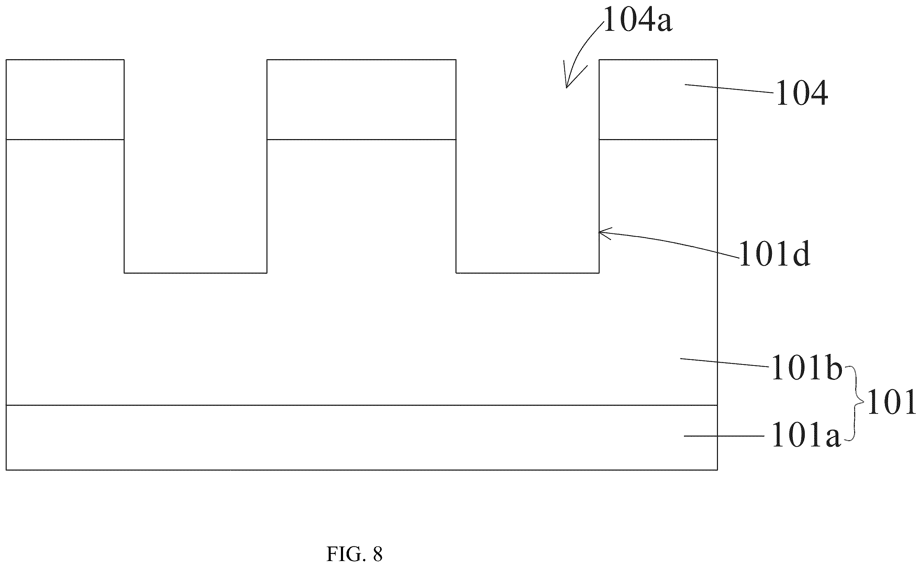

Referring to FIG. 8, the manufacturing method includes forming opening(s) 101d or groove(s) 101d that extend into the epitaxial layer 101b. An etching process may be performed on the epitaxial layer 101b through the patterned mask 104 to form the opening(s) 101d. In some embodiments, the etching process is performed on the epitaxial layer 101b exposed from the opening(s) 104a of the patterned mask 104. The etching process may be performed on the epitaxial layer 101b exposed from the patterned mask 104 to remove a portion of the epitaxial layer 101b exposed from the patterned mask 104. In some embodiments, the etching process may be a plasma dry etching process or other etching processes.

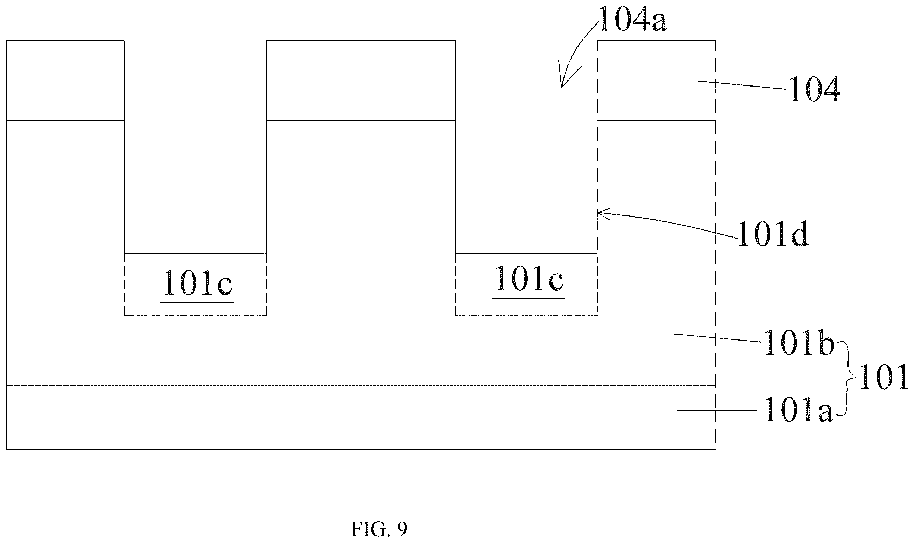

Referring to FIG. 9, the manufacturing method includes implanting a dopant into the epitaxial layer 101b exposed from the opening(s) 101d to form the doped region(s) 101c of the epitaxial layer 101b. The doped region(s) 101c may be formed by performing diffusion or ion implantation from the surface of the epitaxial layer 101b exposed from the opening(s) 104a of the patterned mask 104 and the opening(s) 101d of the epitaxial layer 101b. In some embodiments, a doped region 101c is formed at the bottom of an opening 101d. The conductivity type of the substrate 101a and the conductivity type of the epitaxial layer 101b are different from the conductivity type of the doped region(s) 101c. In some embodiments, the doped region(s) 101c has/have a P type, and the epitaxial layer 101b has an N type. The doped region(s) 101c include a P type dopant, and the P type dopant may be, for example, boron, aluminum, gallium, indium, and so on. In some embodiments, the P type dopant included in the doped region(s) 101c is aluminum.

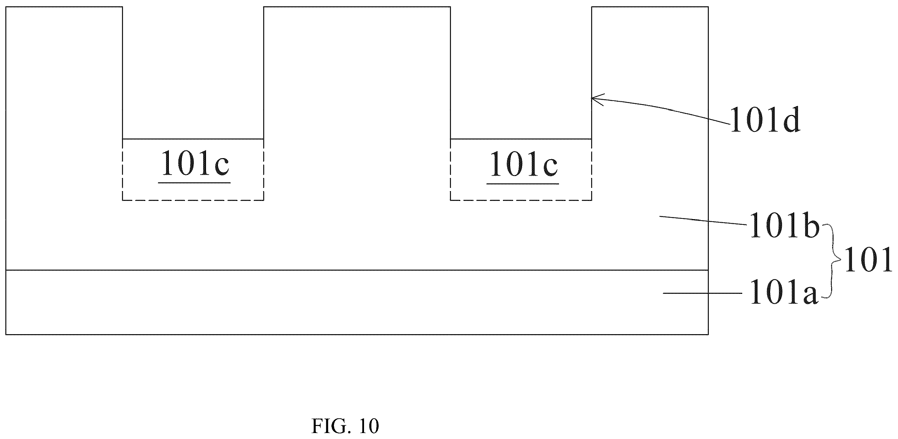

Referring to FIG. 10, in some embodiments, after the diffusion or ion implantation process, the patterned mask 104 is removed. In some embodiments, an etching process, such as a plasma dry etching process, is performed on the patterned mask 104 to remove the patterned mask 104.

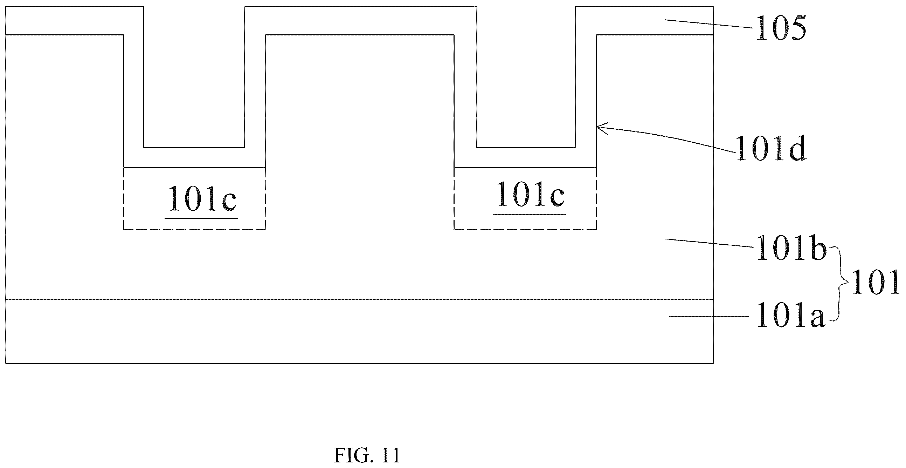

Referring to FIG. 11, in some embodiments, the manufacturing method includes forming a protective layer 105 on the epitaxial layer 101b to protect the epitaxial layer 101b and the doped region(s) 101c during an annealing process. In some embodiments, after removing the patterned mask 104, the protective layer 105 is placed on and covering the surface of the epitaxial layer 101b. In some embodiments, the protective layer 105 includes carbon. After forming the protective layer 105, the annealing process, such as rapid thermal annealing (RTA) or laser annealing, is performed on the doped region(s) 101c, to cause activation of the doped ions in the doped region(s) 101c.

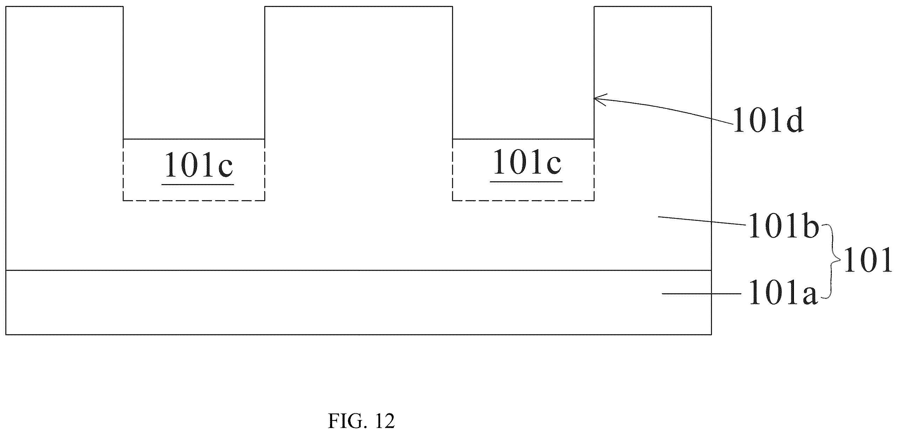

Referring to FIG. 12, after the annealing process, the protective layer 104 may be removed by dry thermal oxidation, plasma dry etching or other etching processes.

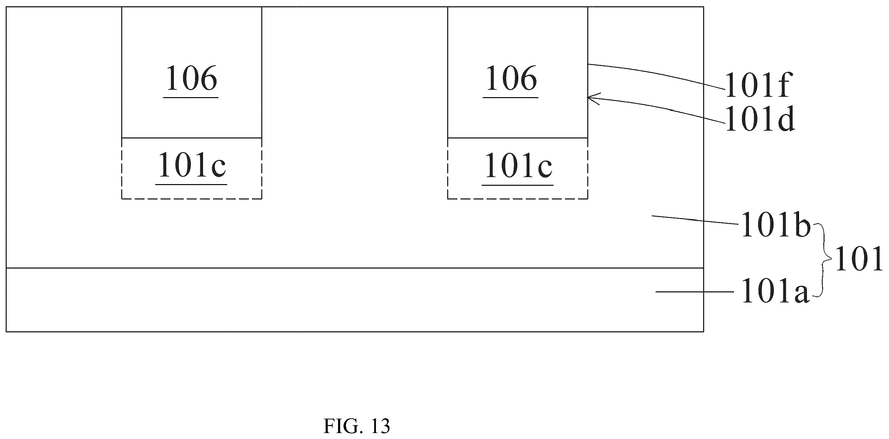

Referring to FIG. 13, the manufacturing method includes filling the opening(s) 101d with sacrificial member(s) 106 to cover the doped region(s) 101c. A sacrificial member 106 is used to protect the doped region 101c and prevent the doped region 101c from reacting with other materials in subsequent processes. In some embodiments, the sacrificial member 106 is placed on the doped region 101c by depositing or other approaches to cover the doped region 101c, and completely fills the opening 101d. In some embodiments, the sacrificial member 106 is in contact with the sidewall 101f of the opening 101d. In some embodiments, the sacrificial member 106 includes an insulating material, such as nitride, oxynitride, silicon nitride (SiN), and the like.

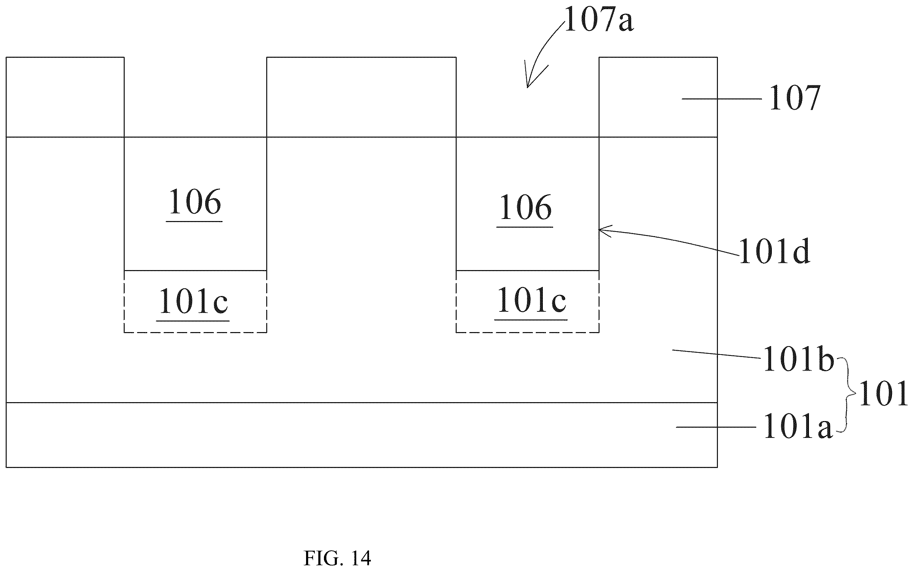

Referring to FIG. 14, the manufacturing method includes disposing a first dielectric layer 107 on the epitaxial layer 101b. In some embodiments, the first dielectric layer 107 is formed on the surface of the epitaxial layer 101b and covers the surface of the epitaxial layer 101b. The first dielectric layer 107 includes a dielectric material, such as an oxide, silicon oxide (SiO₂), and the like. In some embodiments, the first dielectric layer 107 is disposed by use of thermal oxidation. In some embodiments, the first dielectric layer 107 is formed by use of thermal oxidation or other deposition methods. In some embodiments, the formation of the first dielectric layer 107 includes oxidizing the semiconductor material on the surface of the epitaxial layer 101b by thermal oxidation to form the first dielectric layer 107. In some embodiments, the formation of the first dielectric layer 107 includes depositing a dielectric material on the epitaxial layer 101b by use of other deposition methods, and then performing an etching process on a portion of the dielectric material to remove a portion of the dielectric material to form opening(s) 107a. A sacrificial member 106 is exposed from an opening 107a of the first dielectric layer 107. In some embodiments, the first dielectric layer 107 is not disposed on the sacrificial member(s) 106.

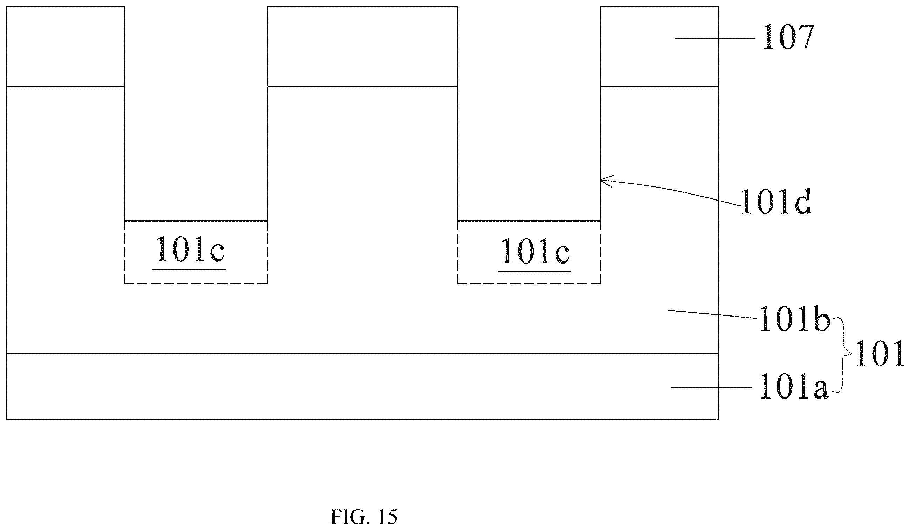

Referring to FIG. 15, the manufacturing method includes removing the sacrificial member(s) 106 from the opening(s) 101d. In some embodiments, the sacrificial member(s) 106 are removed after the first dielectric layer 107 is formed. In some embodiments, an etching process, such as a plasma dry etching process, is performed on the sacrificial member(s) 106 to remove the sacrificial member(s) 106. After removing the sacrificial member(s) 106, the doped region(s) 101c are exposed from the opening(s) 107a of the first dielectric layer 107.

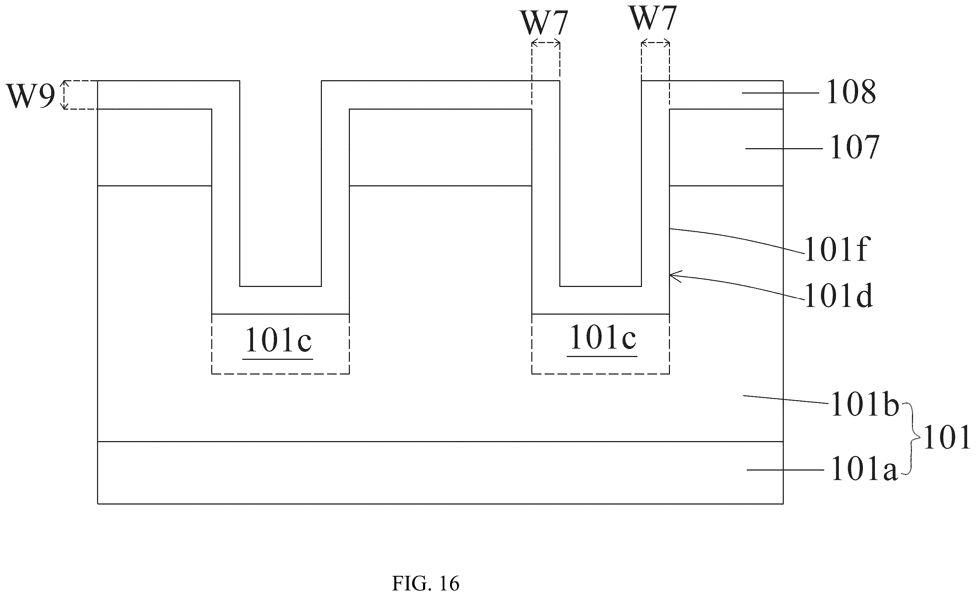

Referring to FIG. 16, the manufacturing method includes disposing a second dielectric layer 108 on the first dielectric layer 107 and the doped region(s) 101c. In some embodiments, the second dielectric layer 108 is formed on exposed surfaces such as the surface and sidewalls of the first dielectric layer 107, the sidewall(s) 101f of the opening(s) 101d, and the doped region(s) 101c, and covers the first dielectric layer 107 and the exposed portion of the epitaxial layer 101b. In some embodiments, the doped region(s) 101c are completely covered by the second dielectric layer 108. In some embodiments, the second dielectric layer 108 is conformal to the sidewall 101f of an opening 101d. In some embodiments, the second dielectric layer 108 conformal to the sidewall 101f of the opening 101d has a uniform thickness W7 along the sidewall 101f of the opening 101d. In some embodiments, the second dielectric layer 108 on the upper surface of the first dielectric layer 107 has a uniform thickness W9 along the upper surface of the first dielectric layer 107. In some embodiments, the thickness W7 is substantially greater than or equal to the thickness W9. In some embodiments, the thickness of the entire second dielectric layer 108 is uniform, that is, the thickness W7 is substantially equal to the thickness W9.

The second dielectric layer 108 includes a dielectric material, such as oxide, silicon oxide (SiO₂), and the like. In some embodiments, the second dielectric layer 108 is disposed by thermal oxidation. In some embodiments, the second dielectric layer 108 is formed by thermal oxidation or other deposition methods. In some embodiments, the formation of the second dielectric layer 108 includes oxidizing the semiconductor material on the surface of the epitaxial layer 101b by thermal oxidation to form the second dielectric layer 108. In some embodiments, the formation of the second dielectric layer 108 includes oxidizing the semiconductor material on sidewall(s) 101f of the opening(s) 101d of the epitaxial layer 101b by thermal oxidation to form the second dielectric layer 108. In some embodiments, the second dielectric layer 108 is not formed on the upper surface of the first dielectric layer 107 or the sidewalls of the first dielectric layer 107.

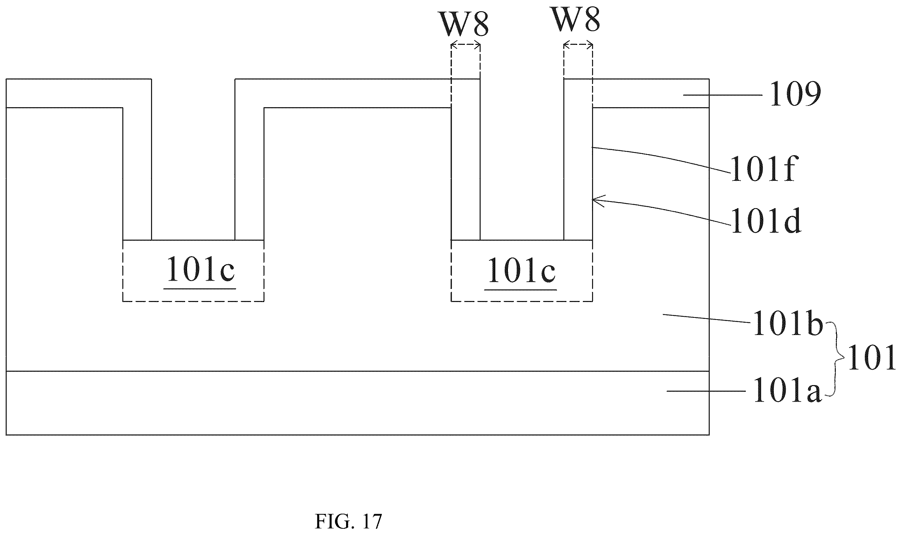

Referring to FIG. 17, the manufacturing method includes removing a first portion of the second dielectric layer 108 to expose a portion of the doped region 101c. In some embodiments, an etching process, such as a plasma dry etching process, is performed on the first portion of the second dielectric layer 108 covering the doped region 101c to remove the first portion of the second dielectric layer 108. In some embodiments, during the removal of the first portion of the second dielectric layer 108, a second portion of the second dielectric layer 108 in contact with the first dielectric layer 107 is also removed. The second portion of the second dielectric layer 108 and a portion of the first dielectric layer 107 are removed simultaneously. In some embodiments, while removing the first portion of the second dielectric layer 108, a portion of the first dielectric layer 107 on the upper surface of the epitaxial layer 101b, a portion of the second dielectric layer 108 on the first dielectric layer 107, and/or a portion of the second dielectric layer 108 on the sidewalls 101f of the opening(s) 101d of the epitaxial layer 101b are also removed simultaneously, thereby forming a remaining portion 109 of the first dielectric layer 107 and the second dielectric layer 108. In some embodiments, after forming the remaining portion 109, the doped region(s) 101c are exposed from the remaining portion 109. In some embodiments, the remaining portion 109 of the first dielectric layer 107 and the second dielectric layer 108 has a uniform thickness W8 along the sidewalls 101f of the opening(s) 101d. In some embodiments, the thickness W7 is substantially greater than the thickness W8.

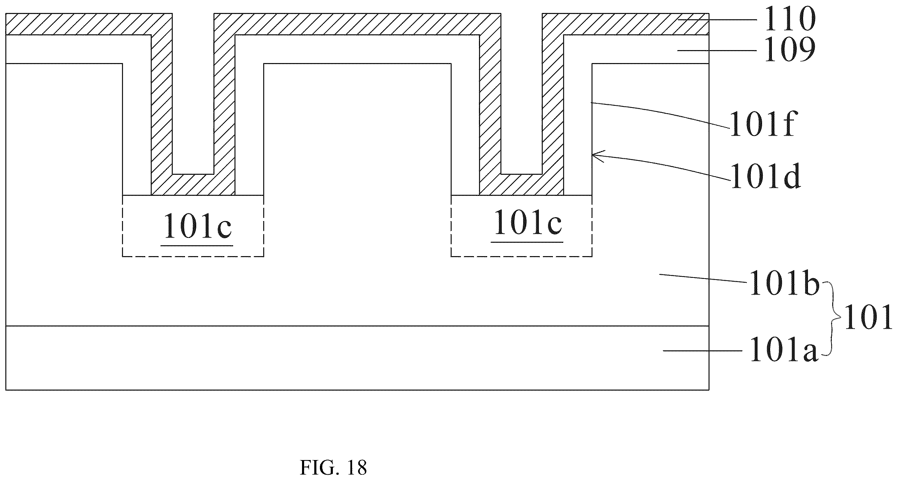

Referring to FIG. 18, the manufacturing method includes disposing a contact material 110 on the portion of the doped region 101c. The contact material 110 is disposed on the portion of the doped region 101c and on the remaining portion 109 of the first dielectric layer 107 and the second dielectric layer 108. During disposing of the contact material 110 on the portion of the doped region 101c, the contact material 110 is disposed on the remaining portion 109 of the first dielectric layer 107 and the second dielectric layer 108. In some embodiments, the contact material 110 covers the remaining portion 109 and the portion of the doped region 101c exposed from the remaining portion 109. In some embodiments, the contact material 110 is disposed to cover the remaining portion 109 and the portion of the doped region 101c exposed from the remaining portion 109 by electroplating, chemical vapor deposition (CVD), or other deposition methods. In some embodiments, the contact material 110 includes a metal material, such as nickel (Ni), titanium (Ti), cobalt (Co), platinum (Pt), tantalum (Ta), tungsten (W), or other metals.

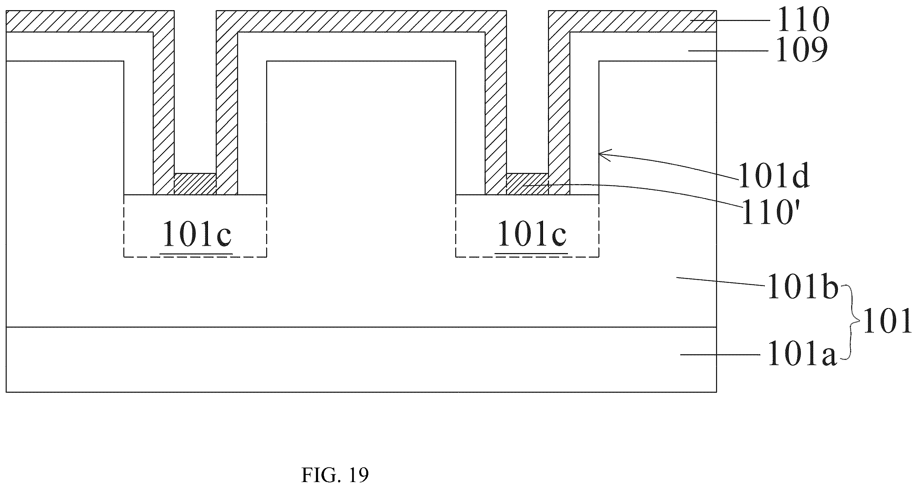

Referring to FIG. 19 to FIG. 20, the manufacturing method includes forming a contact member 101e from the contact material 110 and the portion of the doped region 101c. Referring to FIG. 19, after the contact material 110 is disposed on the portion of the doped region 101c exposed from the remaining portion 109 and on the remaining portion 109, rapid thermal processing (RTP) or other thermal processing may be performed on the contact material 110 and the doped region 101c to form a contact member material 110' based on the contact material 110 and the portion of the doped region 101c in contact with the contact material 110. In some embodiments, the contact member material 110' includes silicide. In some embodiments, the contact member material 110' includes nickel silicide (NiSi), titanium silicide (TiSi), cobalt silicide (CoSi), platinum silicide (PtSi), tantalum silicide (TaSi), tungsten silicide (WSi), or other silicide metals.

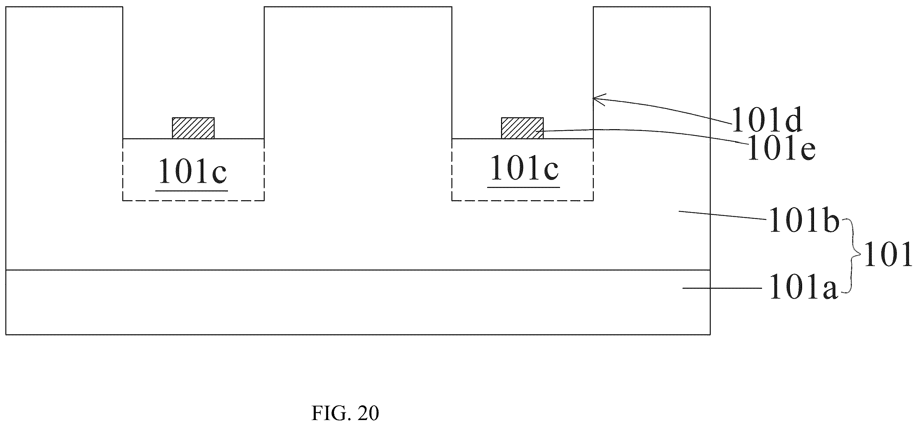

Referring to FIG. 20, the manufacturing method includes removing the remaining portion 109. During the removal of the remaining portion 109, the contact material 110 on the remaining portion 109 is removed. In some embodiments, after the contact member material 110' is formed, the remaining portion 109 and the contact material 110 other than the contact member material 110' are removed to form the contact member 101e. In some embodiments, an etching process, such as a plasma dry etching process, is performed on the remaining portion 109 and the contact material 110 other than the contact member material 110', to remove the remaining portion 109 and the contact material 110 other than the contact member material 110'. In some embodiments, the contact member 101e includes silicide. In some embodiments, the contact member 101e includes nickel silicide (NiSi), titanium silicide (TiSi), cobalt silicide (CoSi), platinum silicide (PtSi), tantalum silicide (TaSi), tungsten silicide (WSi) or other silicide metals. In some embodiments, the contact member 101e is formed after rapid thermal processing (RTP) is performed on the contact material 110 and the portion of the doped region 101c.

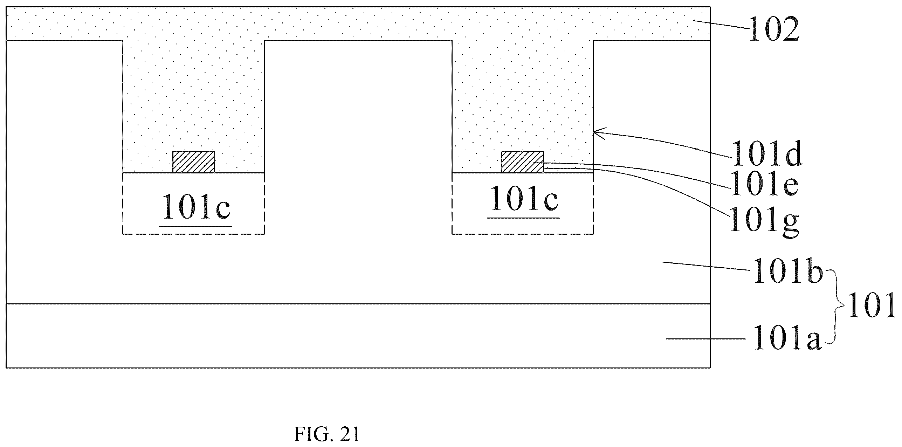

Referring to FIG. 21, in some embodiments, the manufacturing method includes forming a barrier layer 102 on the epitaxial layer 101b, the contact member 101e, and the doped region 101c. In some embodiments, the barrier layer 102 covers the epitaxial layer 101b and the doped region 101c, and covers and surrounds the contact member 101e. In some embodiments, forming the barrier layer 102 includes covering the epitaxial layer 101b, the contact member 101e, and the doped region 101c with a barrier material of the barrier layer 102 by electroplating, chemical vapor deposition (CVD), or other deposition methods. The barrier material includes a metal material or a Schottky metal, such as platinum (Pt), titanium (Ti), nickel (Ni), palladium (Pd), molybdenum (Mo), and so on.

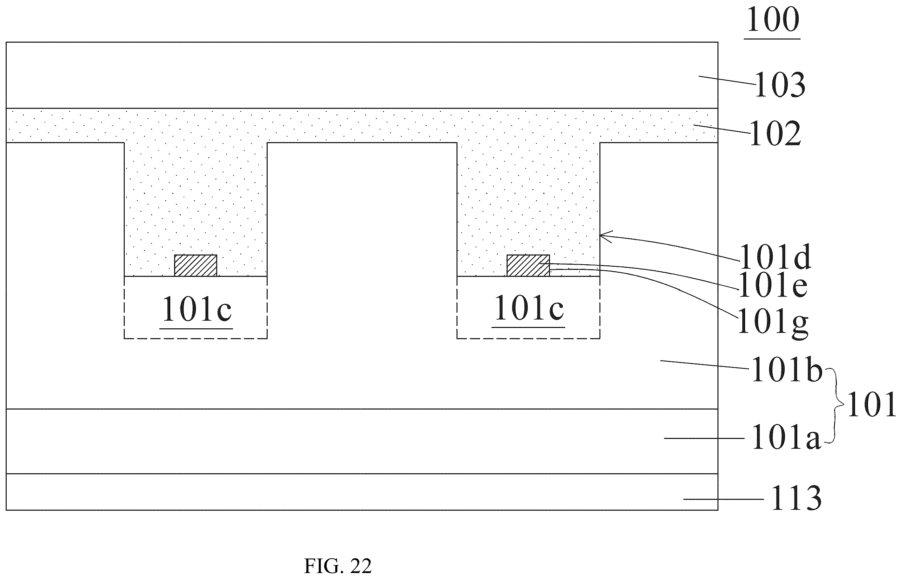

Referring to FIG. 22, in some embodiments, the manufacturing method includes forming a first electrode 103 on the barrier layer 102. In some embodiments, after the barrier layer 102 is formed, the first electrode 103 is formed on the barrier layer 102. In some embodiments, forming the first electrode 103 includes covering the barrier layer 102 with an electrode material of the first electrode 103 by electroplating, chemical vapor deposition (CVD) or other deposition methods. In some embodiments, the manufacturing method includes forming a second electrode 113 below the substrate 101a. In some embodiments, after the barrier layer 102 is formed, the second electrode 113 is formed below the substrate 101a. In some embodiments, forming the second electrode 113 includes disposing an electrode material of the second electrode 113 under and covering the substrate 101a by electroplating, chemical vapor deposition (CVD) or other deposition methods. In some embodiments, the electrode material includes a conductive material, e.g., a metal material such as copper (Cu), silver (Ag), gold (Au), etc. In some embodiments, the first electrode 103 is an anode or positive electrode, and the second electrode 113 is a cathode or negative electrode. FIG. 22 shows the power semiconductor structure 100 of FIG. 1.

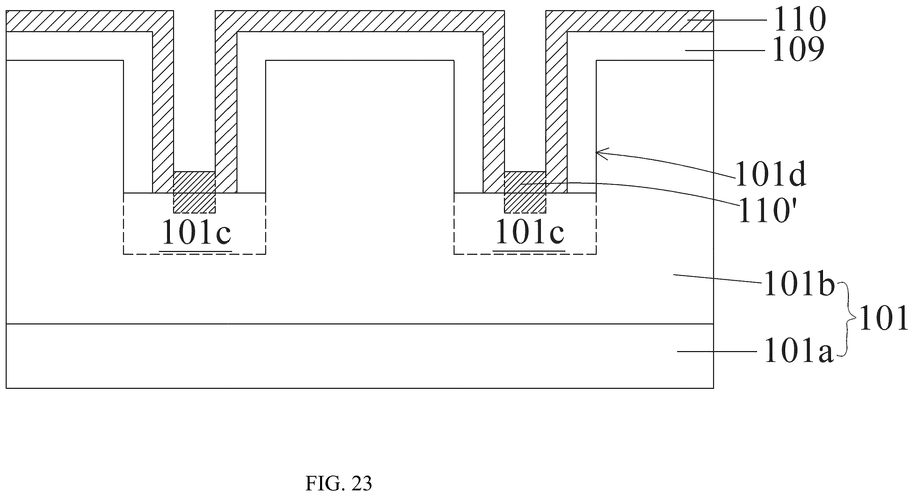

FIG. 6 to FIG. 18 and FIG. 23 to FIG. 26 illustrate one or more stages in a manufacturing method of the power semiconductor structure 200 according to some embodiments of the present application. Specifically, the manufacturing method for the power semiconductor structure 200 is similar to the manufacturing method for the power semiconductor structure 100 as shown in FIG. 6 to FIG. 18, except that the contact member 101e formed by the contact material 110 and the portion of the doped region 101c is partially surrounded by the doped region 101c, as shown in FIG. 23 to FIG. 26.

Referring to FIG. 23, the manufacturing method includes forming the contact member 101e from the contact material 110 and the portion of the doped region 101c. After the contact material 110 is disposed on the portion of the doped region 101c exposed from the remaining portion 109 and on the remaining portion 109, the contact material 110 and the doped region 101c are processed by rapid thermal processing (RTP) or other thermal processing to form the contact material 110 and the portion of the doped region 101c in contact with the contact material 110 into the contact member material 110'.

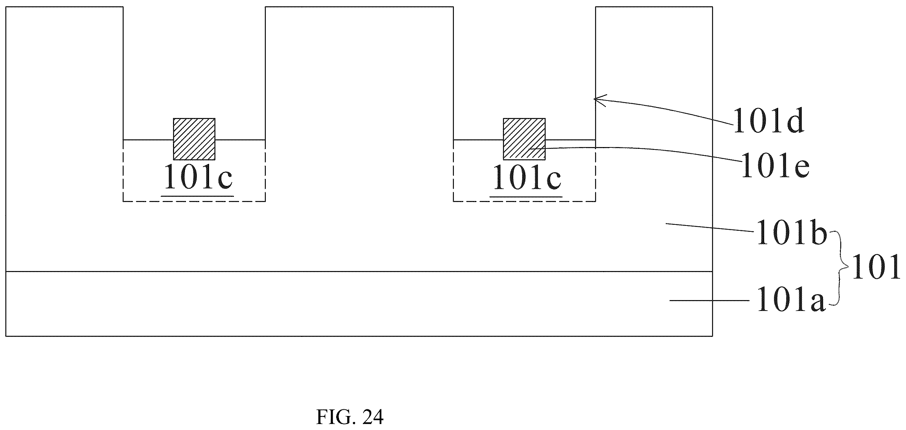

Referring to FIG. 24, the manufacturing method includes removing the remaining portion 109 and the contact material 110 on the remaining portion 109 to form the contact member 101e. The contact member 101e is at least partially surrounded by the doped region 101c and at least partially on the epitaxial layer 101b or the doped region 101c. In some embodiments, an etching process, such as a plasma dry etching process, is performed on the remaining portion 109 and the contact material 110 other than the contact member material 110' to remove the remaining portion 109 and the contact material 110 other than the contact member material 110'. In some embodiments, the contact member 101e includes silicide. In some embodiments, the contact member 101e includes nickel silicide (NiSi), titanium silicide (TiSi), cobalt silicide (CoSi), platinum silicide (PtSi), tantalum silicide (TaSi), tungsten silicide (WSi) or other silicide metals.

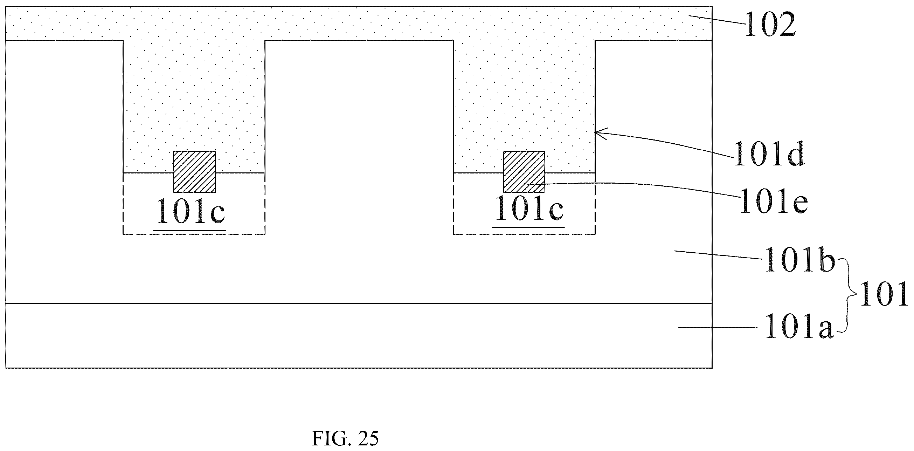

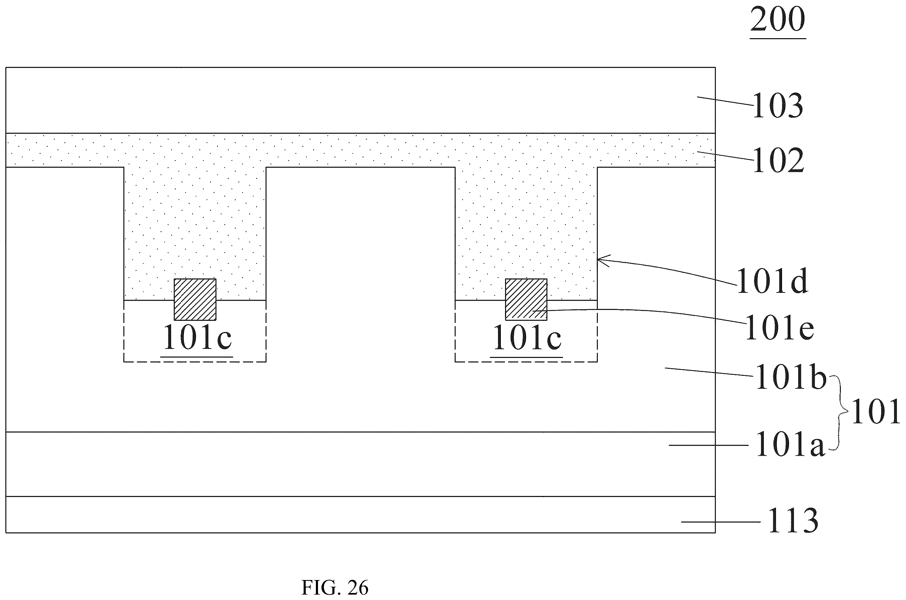

Referring to FIG. 25, in some embodiments, the manufacturing method includes forming a barrier layer 102 on the epitaxial layer 101b, the contact member 101e, and the doped region 101c. In some embodiments, the barrier layer 102 covers the epitaxial layer 101b and the doped region 101c, and covers and surrounds a portion of the contact member 101e. Referring to FIG. 26, in some embodiments, the manufacturing method includes forming a first electrode 103 on the barrier layer 102 and forming a second electrode 113 under the substrate 101a. FIG. 26 shows the power semiconductor structure 200 of FIG. 3.

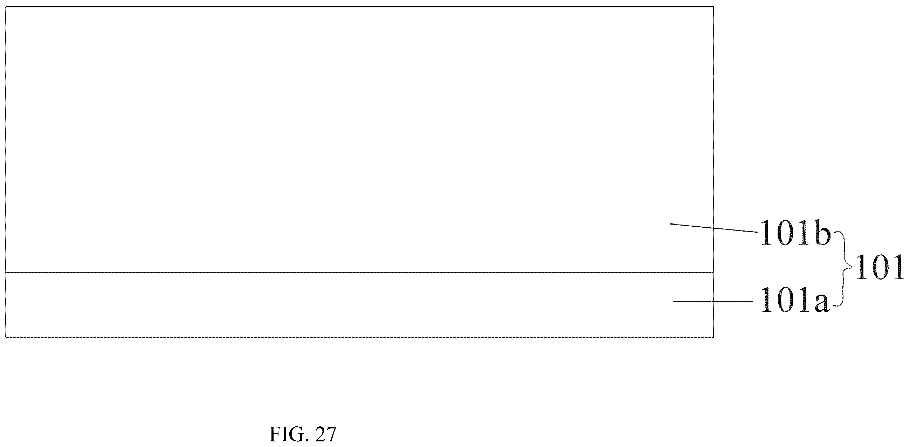

FIG. 27 to FIG. 42 illustrate one or more stages in a manufacturing method of the power semiconductor structure 300 according to some embodiments of the present application. At least some of these figures have been simplified to facilitate a better understanding of aspects of the present disclosure.

Referring to FIG. 27, the manufacturing method includes forming an epitaxial layer 101b on a substrate 101a. The substrate 101a and the epitaxial layer 101b respectively include semiconductor materials such as silicon carbide (SiC). In some embodiments, the substrate 101a is an N-type or P-type semiconductor material. Epitaxial growth is performed on the substrate 101a to form the epitaxial layer 101b. In some embodiments, the epitaxial growth is simultaneously performed with dopant implantation, the implantation has an N-type dopant, and the N-type dopant may be, for example, phosphorus (P) or arsenic (As), to form an N-type epitaxial layer 101b. In some embodiments, the substrate 101a and the epitaxial layer 101b have the same conductivity type doping, for example, the substrate 101a and the epitaxial layer 101b are both N-type. In some embodiments, the doping concentration of the substrate 101a is substantially greater than the doping concentration of the epitaxial layer 101b.

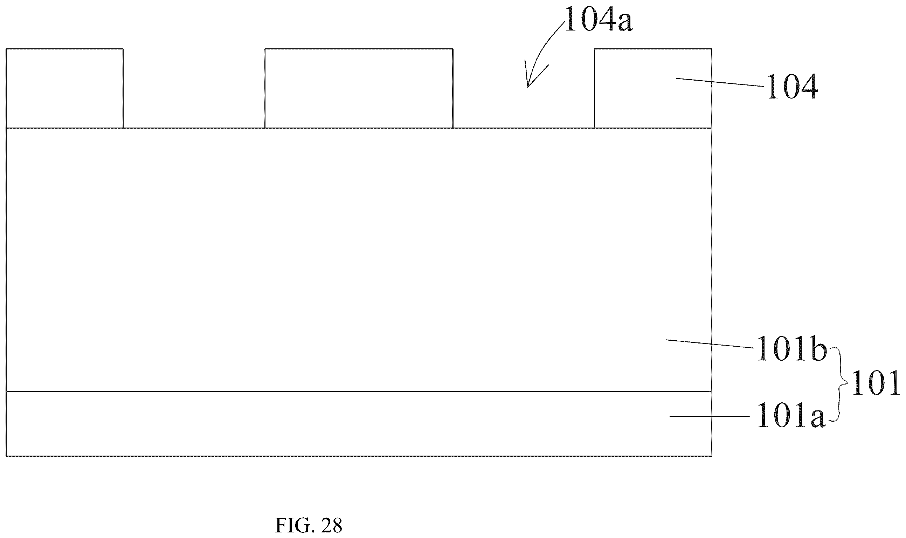

Referring to FIG. 28, in some embodiments, the manufacturing method includes disposing a patterned mask 104 on the epitaxial layer 101 b. In some embodiments, the patterned mask 104 includes a photoresist or an oxide, etc. The patterned mask 104 has opening(s) 104a, and the epitaxial layer 101b is at least partially exposed from the patterned mask 104.

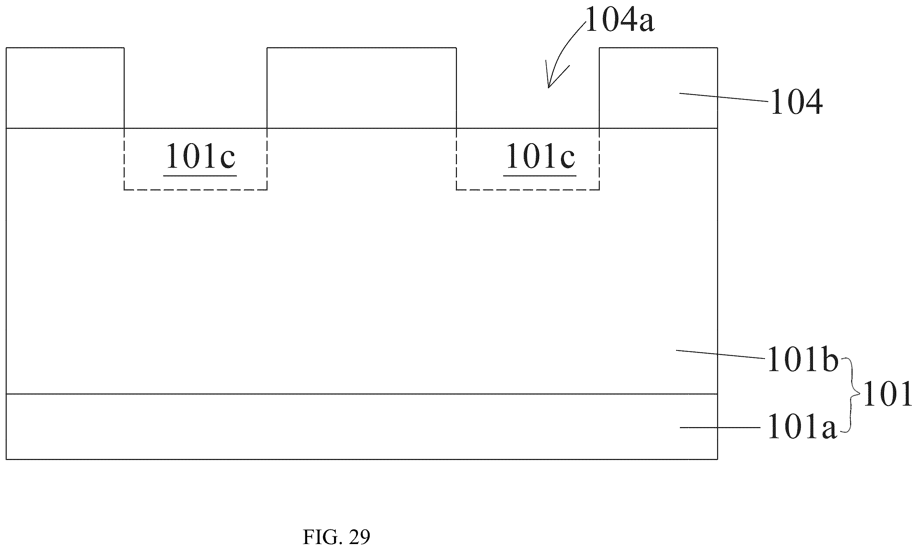

Referring to FIG. 29, the manufacturing method includes implanting a dopant into the epitaxial layer 101b exposed from the patterned mask 104 to form doped region(s) 101c. The doped region 101c may be formed by performing diffusion or ion implantation on the surface of the epitaxial layer 101b exposed from the opening(s) 104a of the patterned mask 104. The conductivity type of the substrate 101a and the conductivity type of the epitaxial layer 101b are different from the conductivity type of the doped region(s) 101c. In some embodiments, the doped region(s) 101c have a P-type and the epitaxial layer 101b has an N-type. The doped region(s) 101c include a P-type dopant, which may be, for example, boron, aluminum, gallium, indium, etc. In some embodiments, the P-type dopant included in the doped region(s) 101c is boron.

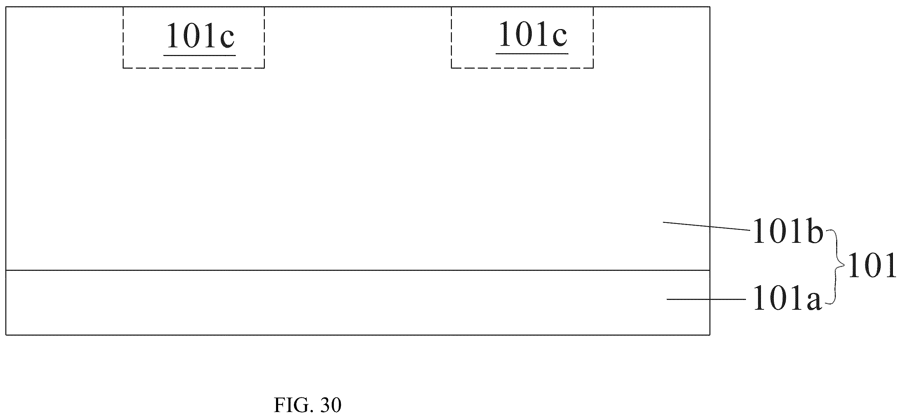

Referring to FIG. 30, in some embodiments, after the diffusion or ion implantation process, the patterned mask 104 is removed. In some embodiments, an etching process, such as a plasma dry etching process, is performed on the patterned mask 104 to remove the patterned mask 104.

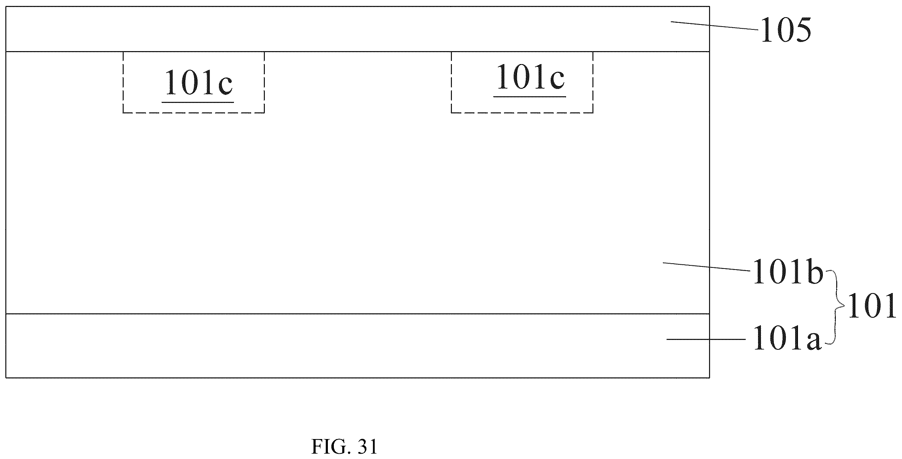

Referring to FIG. 31, in some embodiments, the manufacturing method includes forming a protective layer 105 on the epitaxial layer 101b to protect the epitaxial layer 101b and the doped region(s) 101c during an annealing process. In some embodiments, after removing the patterned mask 104, the protective layer 105 is disposed on and covering the surface of the epitaxial layer 101b. In some embodiments, the protective layer 105 includes carbon. After forming the protective layer 105, an annealing process, such as rapid thermal annealing (RTA) or laser annealing, is performed on the doped region(s) 101c, to activate the doped ions in the doped region(s) 101c.

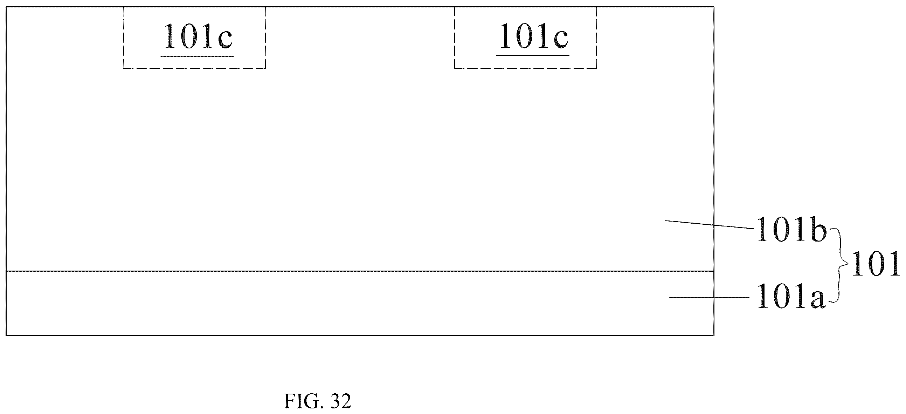

Referring to FIG. 32, after the annealing process, the protective layer 105 may be removed by dry thermal oxidation, plasma dry etching or other etching processes.

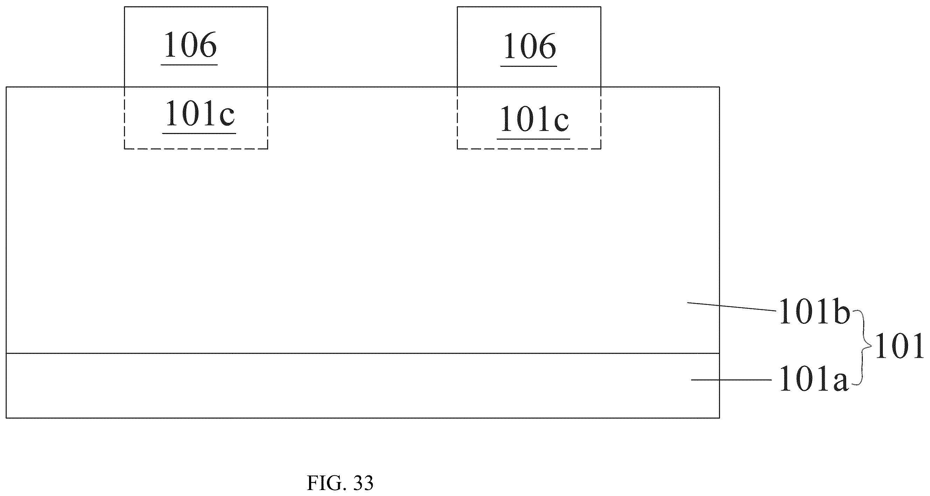

Referring to FIG. 33, the manufacturing method includes providing sacrificial member(s) 106 to cover the doped region(s) 101c. A sacrificial member 106 is used to protect the doped region 101c and prevent the doped region 101c from reacting with other materials in subsequent processes. The sacrificial member 106 protrudes from the epitaxial layer 101b. In some embodiments, the sacrificial member 106 is placed on and covering the doped region 101c by deposition or other approaches. In some embodiments, the sacrificial member 106 includes an insulating material, such as nitride, oxynitride, silicon nitride (SiN), and the like.

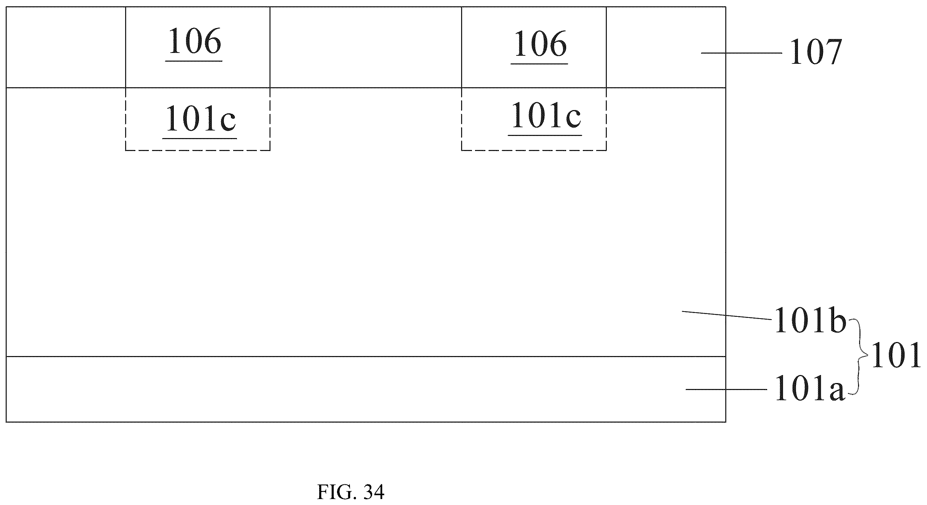

Referring to FIG. 34, the manufacturing method includes disposing a first dielectric layer 107 on the epitaxial layer 101b. In some embodiments, the first dielectric layer 107 is formed on the surface of the epitaxial layer 101b and covers the surface of the epitaxial layer 101b. The first dielectric layer 107 includes a dielectric material, such as an oxide, silicon oxide (SiO₂), and so on. In some embodiments, the first dielectric layer 107 is disposed by thermal oxidation. In some embodiments, the first dielectric layer 107 is formed by thermal oxidation or other deposition methods. In some embodiments, the formation of the first dielectric layer 107 includes oxidizing the semiconductor material on the surface of the epitaxial layer 101b by thermal oxidation to form the first dielectric layer 107. In some embodiments, the first dielectric layer 107 is not disposed on the sacrificial member(s) 106.

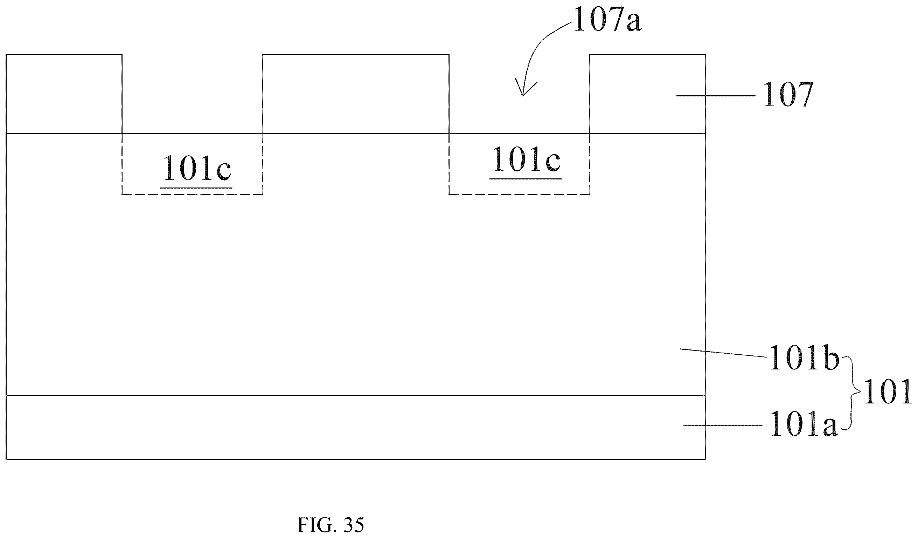

Referring to FIG. 35, the manufacturing method includes removing the sacrificial member(s) 106 to form opening(s) 107a surrounded by the first dielectric layer 107 and exposing the doped region(s). In some embodiments, after forming the first dielectric layer 107, the sacrificial member(s) 106 is/are removed. In some embodiments, an etching process, such as a plasma dry etching process, is performed on the sacrificial member(s) 106 to remove the sacrificial member(s) 106. After removing the sacrificial member(s) 106, the doped region(s) 101c are exposed from the opening(s) 107a of the first dielectric layer 107.

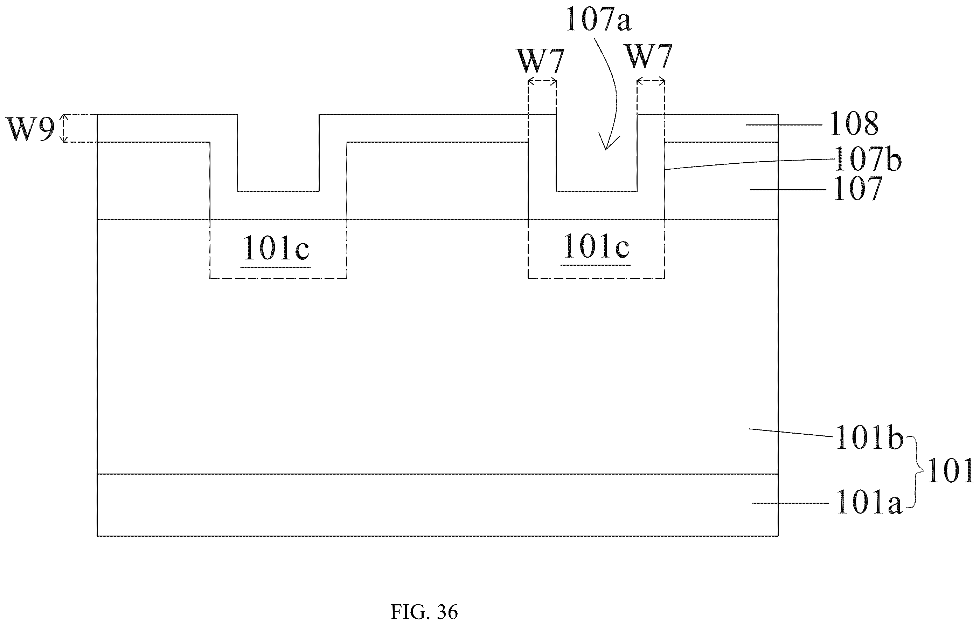

Referring to FIG. 36, the manufacturing method includes disposing a second dielectric layer 108 on the first dielectric layer 107 and the doped region(s) 101c. In some embodiments, the second dielectric layer 108 is conformal to sidewall 107b of the opening 107a. In some embodiments, the second dielectric layer 108 conformal to the sidewall 107b of the opening 107a has a uniform thickness W7 along the sidewall 107b of the opening 107a. In some embodiments, the second dielectric layer 108 on the upper surface of the first dielectric layer 107 has a uniform thickness W9 along the upper surface of the first dielectric layer 107. In some embodiments, the thickness W7 is substantially greater than or equal to the thickness W9. In some embodiments, the thickness of the entire second dielectric layer 108 is uniform, that is, the thickness W7 is substantially equal to the thickness W9. The second dielectric layer 108 includes a dielectric material, such as an oxide, silicon oxide (SiO₂), and so on. In some embodiments, the second dielectric layer 108 is disposed by thermal oxidation. In some embodiments, the second dielectric layer 108 is formed by thermal oxidation or other deposition methods. In some embodiments, the forming of the second dielectric layer 108 includes oxidizing the semiconductor material on the surface of the epitaxial layer 101b by thermal oxidation to form the second dielectric layer 108.

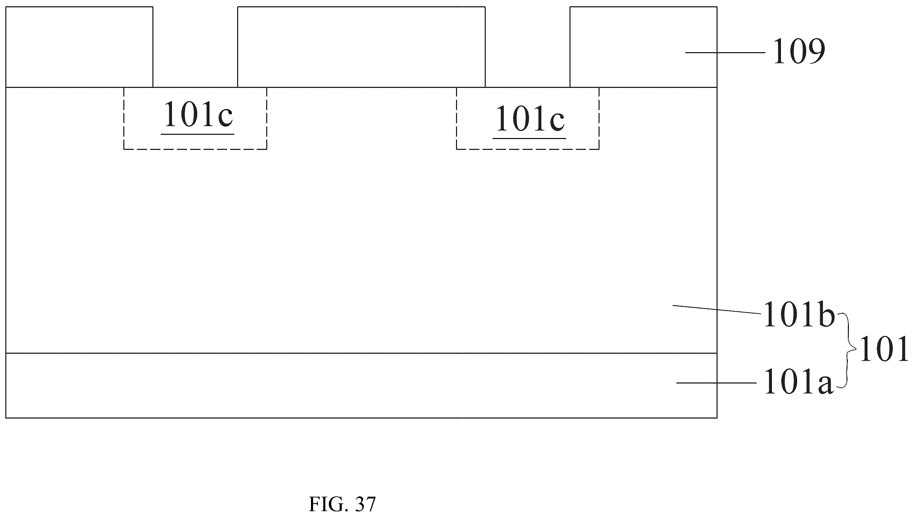

Referring to FIG. 37, the manufacturing method includes removing a first portion of the second dielectric layer 108 to expose a portion of the doped region 101c. In some embodiments, an etching process, such as a plasma dry etching process, is performed on the first portion of the second dielectric layer 108 covering the doped region 101c to remove the first portion of the second dielectric layer 108. In some embodiments, during the removal of the first portion of the second dielectric layer 108, a second portion of the second dielectric layer 108 in contact with the first dielectric layer 107 is also removed. The second portion of the second dielectric layer 108 and a portion of the first dielectric layer 107 are removed simultaneously, thereby forming a remaining portion 109 of the first dielectric layer 107 and the second dielectric layer 108. In some embodiments, after the remaining portion 109 is formed, the doped region 101c is exposed from the remaining portion 109.

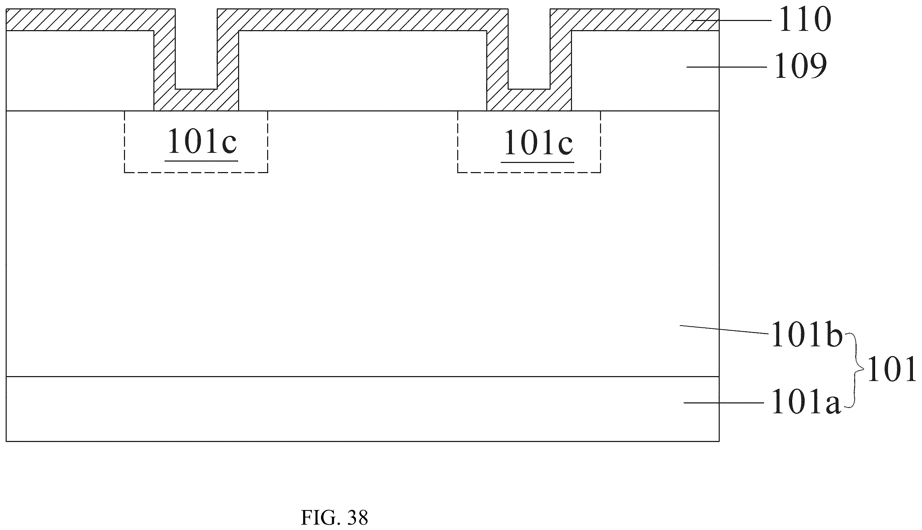

Referring to FIG. 38, the manufacturing method includes disposing a contact material 110 on the portion of the doped region 101c. The contact material 110 is disposed on the portion of the doped region 101c and on the remaining portion 109. In some embodiments, the contact material 110 covers the remaining portion 109 and the portion of the doped region 101c exposed from the remaining portion 109. In some embodiments, the contact material 110 is disposed on and covering the remaining portion 109 and the portion of the doped region 101c exposed from the remaining portion 109 by electroplating, chemical vapor deposition (CVD) or other deposition methods. In some embodiments, the contact material 110 includes a metal material, such as nickel (Ni), titanium (Ti), cobalt (Co), platinum (Pt), tantalum (Ta), tungsten (W) or other metals.

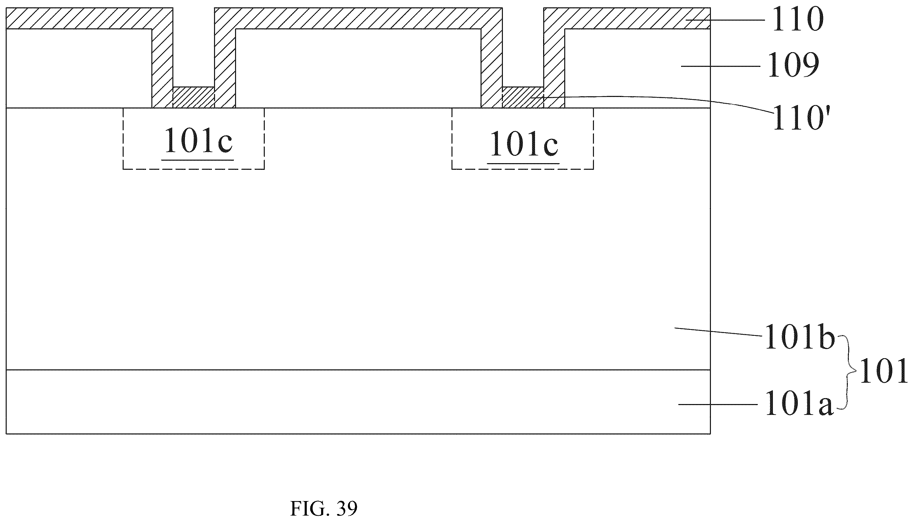

Referring to FIG. 39 to FIG. 40, the manufacturing method includes forming a contact member 101e from the contact material 110 and the portion of the doped region 101c. Referring to FIG. 39, after the contact material 110 is disposed on the portion of the doped region 101c exposed from the remaining portion 109 and on the remaining portion 109, rapid thermal processing (RTP) or other thermal processing may be performed on the contact material 110 and the doped region 101c to form a contact member material 110' from the contact material 110 and the portion of the doped region 101c in contact with the contact material 110. In some embodiments, the contact member material 110' includes silicide. In some embodiments, the contact member material 110' includes nickel silicide (NiSi), titanium silicide (TiSi), cobalt silicide (CoSi), platinum silicide (PtSi), tantalum silicide (TaSi), tungsten silicide (WSi), or other silicide metals.

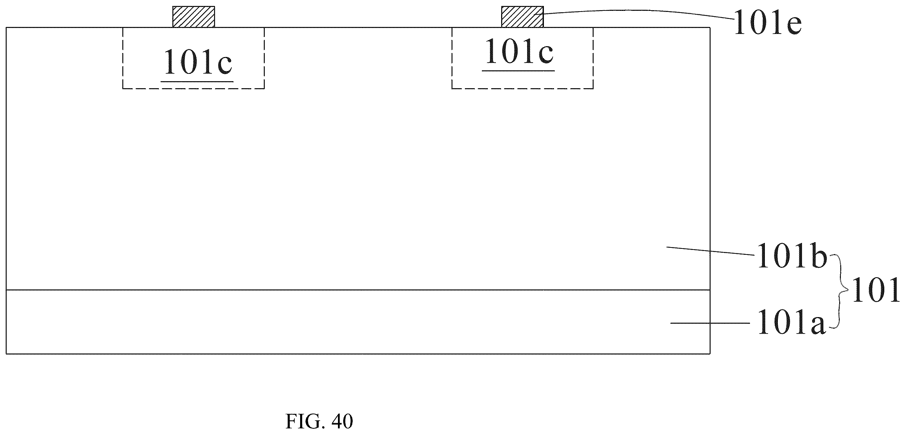

Referring to FIG. 40, the manufacturing method includes removing the remaining portion 109. During the removal of the remaining portion 109, the contact material 110 on the remaining portion 109 is removed. In some embodiments, after the contact member material 110' is formed, the remaining portion 109 and the contact material 110 other than the contact member material 110' are removed to form the contact member 101e. In some embodiments, an etching process, such as a plasma dry etching process, may be performed on the remaining portion 109 and the contact material 110 other than the contact member material 110' to remove the remaining portion 109 and the contact material 110 other than the contact member material 110'. In some embodiments, the contact member 101e includes silicide. In some embodiments, the contact member 101e includes nickel silicide (NiSi), titanium silicide (TiSi), cobalt silicide (CoSi), platinum silicide (PtSi), tantalum silicide (TaSi), tungsten silicide (WSi) or other silicide metals. In some embodiments, the contact member 101e is formed after the contact material 110 and the portion of the doped region 101c are processed by rapid thermal processing (RTP).

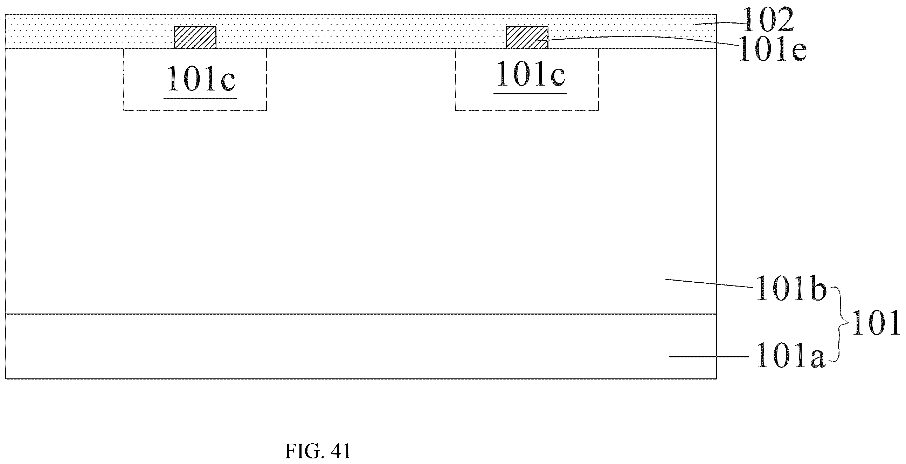

Referring to FIG. 41, in some embodiments, the manufacturing method includes forming a barrier layer 102 on the epitaxial layer 101b, the contact member 101e, and the doped region 101c. In some embodiments, the barrier layer 102 covers the epitaxial layer 101b and the doped region 101c, and covers and surrounds the contact member 101e. In some embodiments, forming the barrier layer 102 includes disposing a barrier material of the barrier layer 102 on and covering the epitaxial layer 101b, the contact member 101e, and the doped region 101c by electroplating, chemical vapor deposition (CVD), or other deposition methods. The barrier material includes a metal material or a Schottky metal, such as platinum (Pt), titanium (Ti), nickel (Ni), palladium (Pd), molybdenum (Mo), and so on.

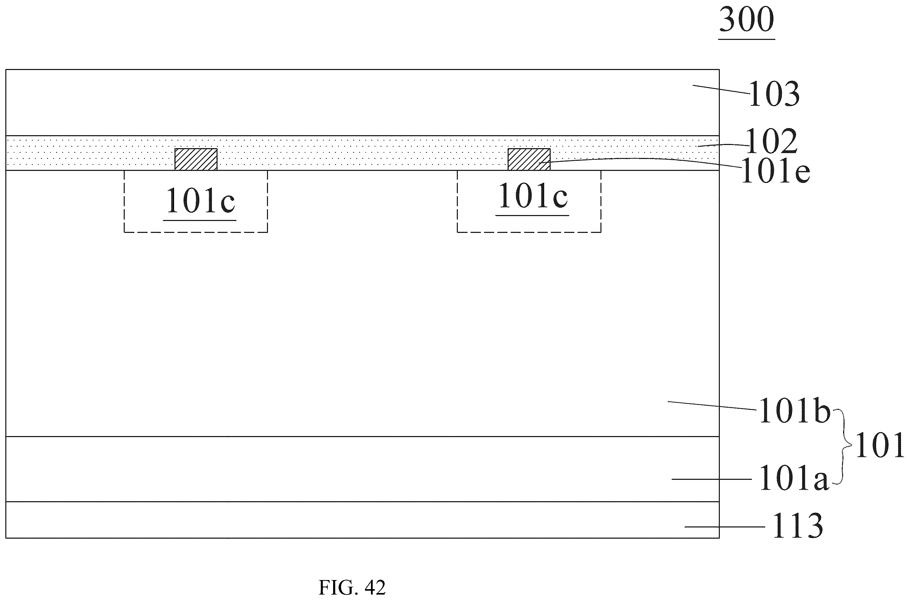

Referring to FIG. 42, in some embodiments, the manufacturing method includes forming a first electrode 103 on the barrier layer 102. In some embodiments, after the barrier layer 102 is formed, the first electrode 103 is formed on the barrier layer 102. In some embodiments, forming the first electrode 103 includes disposing an electrode material of the first electrode 103 on and covering the barrier layer 102 by electroplating, chemical vapor deposition (CVD) or other deposition methods. In some embodiments, the manufacturing method includes forming a second electrode 113 under the substrate 101a. In some embodiments, after the barrier layer 102 is formed, the second electrode 113 is formed under the substrate 101a. In some embodiments, forming the second electrode 113 includes disposing an electrode material of the second electrode 113 under and covering the substrate 101a by electroplating, chemical vapor deposition (CVD) or other deposition methods. In some embodiments, the electrode material includes a conductive material, such as a metal material such as copper (Cu), silver (Ag), gold (Au), and so on. In some embodiments, the first electrode 103 is an anode or positive electrode, and the second electrode 113 is a cathode or negative electrode. FIG. 42 shows the power semiconductor structure 300 of FIG. 4.

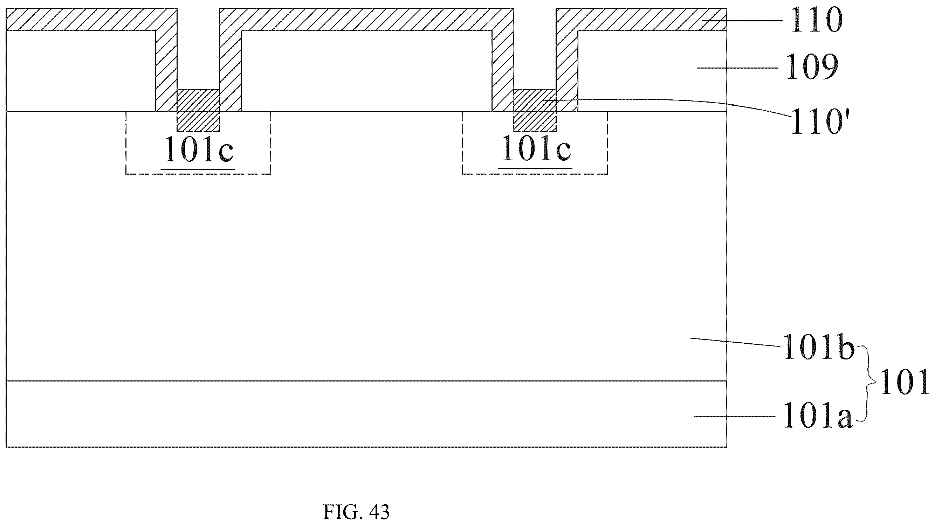

FIG. 27 to FIG. 38 and FIG. 43 to FIG. 46 illustrate one or more stages in a manufacturing method of the power semiconductor structure 400 according to some embodiments of the present application. Specifically, the manufacturing method for the power semiconductor structure 400 is similar to the manufacturing method for the power semiconductor structure 300 shown in FIG. 27 to FIG. 38, except that the contact member 101e formed from the contact material 110 and the portion of the doped region 101c is partially surrounded by the doped region 101c, as shown in FIG. 43 to FIG. 46.

Referring to FIG. 43 to FIG. 44, the manufacturing method includes forming the contact member 101e from the contact material 110 and the portion of the doped region 101c. Referring to FIG. 43, after the contact material 110 is disposed on the portion of the doped region 101c exposed from the remaining portion 109 and on the remaining portion 109, rapid thermal processing (RTP) or other thermal processing is performed on the contact material 110 and the doped region 101c to form the contact member material 110' from the contact material 110 and the portion of the doped region 101c in contact with the contact material 110.

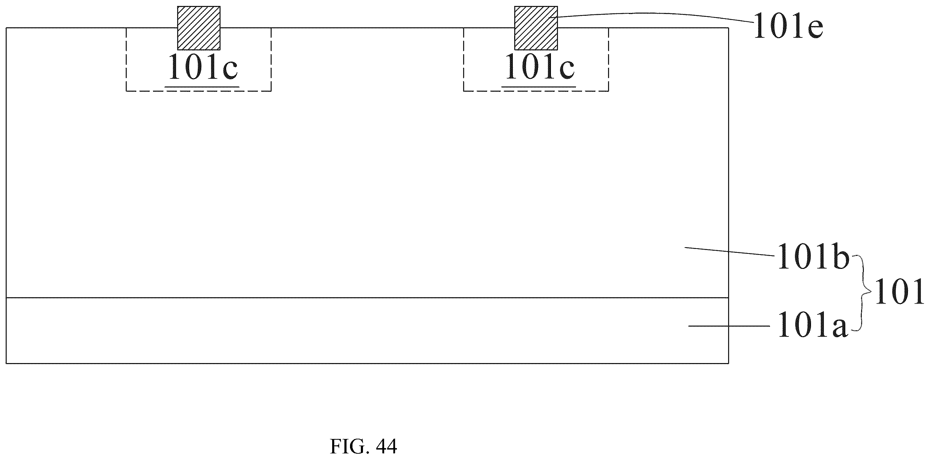

Referring to FIG. 44, the manufacturing method includes removing the remaining portion 109 and the contact material 110 on the remaining portion 109 to form the contact member 101e. The contact member 101e is at least partially surrounded by the doped region 101c and at least partially on the epitaxial layer 101b or the doped region 101c. In some embodiments, an etching process, such as a plasma dry etching process, is performed on the remaining portion 109 and the contact material 110 other than the contact member material 110', to remove the remaining portion 109 and the contact material 110 other than the contact member material 110'. In some embodiments, the contact member 101e includes silicide. In some embodiments, the contact member 101e includes nickel silicide (NiSi), titanium silicide (TiSi), cobalt silicide (CoSi), platinum silicide (PtSi), tantalum silicide (TaSi), tungsten silicide (WSi) or other silicide metals.

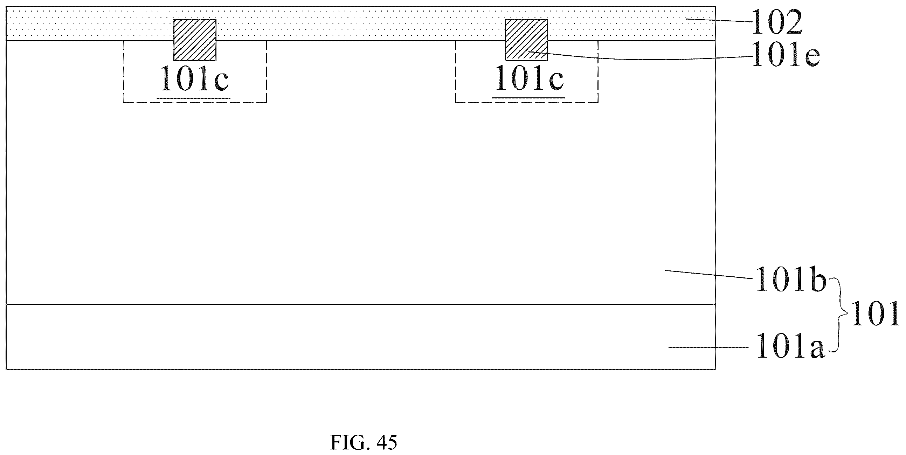

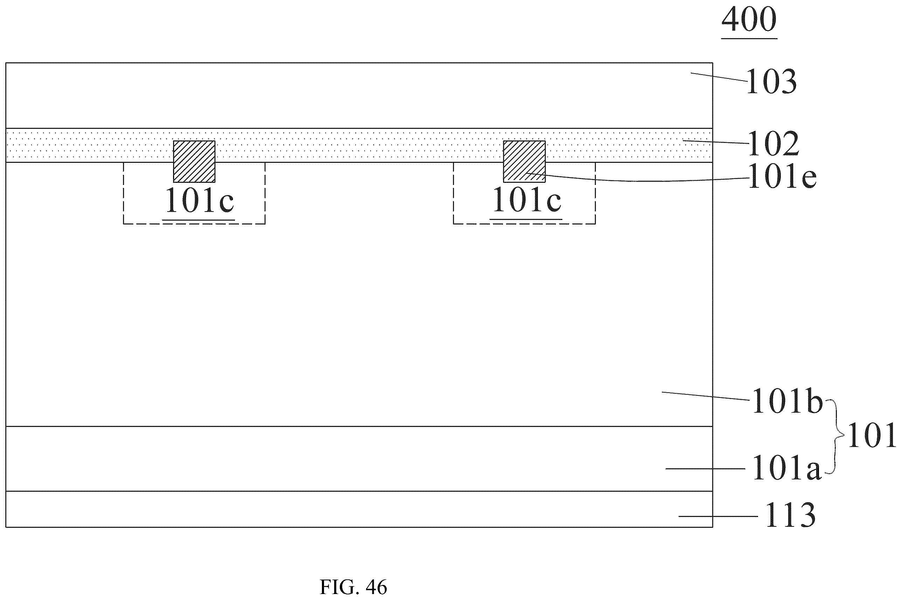

Referring to FIG. 45, in some embodiments, the manufacturing method includes forming a barrier layer 102 on the epitaxial layer 101b, the contact member 101e, and the doped region 101c. In some embodiments, the barrier layer 102 covers the epitaxial layer 101b and the doped region 101c, and covers and surrounds a portion of the contact member 101e. Referring to FIG. 46, in some embodiments, the manufacturing method includes forming a first electrode 103 on the barrier layer 102 and forming a second electrode 113 under the substrate 101a. FIG. 46 shows the power semiconductor structure 400 of FIG. 5.

Since the remaining portion 109 of the first dielectric layer 107 and the second dielectric layer 108 have a uniform thickness W8 along the sidewall 101f of the opening 101d (as shown in FIG. 17), and the contact member 101e is disposed at the center of the surface of the doped region 101c (as shown in FIGs. 20, 24, 40, and 44), the reverse leakage current from the first electrode 103 to the second electrode 113 of the power semiconductor structures 100, 200, 300, and 400 is reduced or even avoided. Moreover, the power semiconductor structures 100, 200, 300, and 400 can withstand a larger current flowing from the first electrode 103 to the epitaxial layer 101b through the barrier layer 102 and the contact member 101e.

According to the structures and processes of the present disclosure described above, under the same purpose and concept, the steps in the above processes may be adjusted or the order of the steps may be changed, to achieve the same or similar semiconductor structure.

In this disclosure, for description convenience, spatially relative terms such as "under," "below," "lower," "on," "upper," "left," "right, " and the like may be used herein to describe the relationship of one component or feature with another or more components or features as shown in the accompanying drawings. Spatially relative terms are intended to cover different orientations of a device in use or operation in addition to the orientations depicted in the accompanying drawings. The device may be oriented in other ways (rotated 90 degrees or in other orientations), and the spatially relative terms used herein may also be interpreted accordingly. It should be understood that when a component is referred to as being "connected to" or "coupled to" another component, it may be directly connected to or coupled to another component, or there may be intermediate components.

As used herein, the terms "approximately," "basically," "substantially" and "about" are used to describe and explain small changes. When used in conjunction with an event or instance, the terms may refer to an embodiment where the event or instance occurs precisely and an embodiment where the event or instance is close to the occurrence. As used herein with respect to a given value or range, the term "about" generally means being within ±10%, ±5%, ±1% or ±0.5% of the given value or range. A range herein may be referred to as being from one endpoint to another endpoint or between two endpoints. All ranges disclosed herein include endpoints unless otherwise specified. The term "substantially coplanar" may refer to a position difference of two surfaces with reference to the same plane being within a few microns (µm), e.g., a position difference with reference to the same plane is within 10 µm, within 5 µm, within 1 µm or within 0.5 µm. When numerical values or characteristics are referred to as being "substantially" the same, the term may refer to a value that is within ±10%, ±5%, ±1% or ±0.5% of the mean value of the values.

The foregoing has outlined features of some embodiments and detailed aspects of the present disclosure. The embodiments described in the present disclosure can be readily used as a basis for designing or modifying other processes and structures in order to facilitate implementation of the same or similar purposes and/or to achieve the same or similar advantages of the embodiments provided herein. Such equivalent constructions do not depart from the spirit and scope of the present disclosure, and various changes, substitutions and modifications may be made without departing from the spirit and scope of the present disclosure.

## Claims

1. A method for manufacturing a power semiconductor structure, comprising:
forming an epitaxial layer on a substrate;
forming an opening extending into the epitaxial layer;
implanting a dopant into the epitaxial layer exposed from the opening to form a doped region of the epitaxial layer;
filling the opening with a sacrificial member to cover the doped region;
disposing a first dielectric layer on the epitaxial layer;
removing the sacrificial member from the opening;
disposing a second dielectric layer on the first dielectric layer and the doped region, wherein the second dielectric layer is conformal to a sidewall of the opening;
removing a first portion of the second dielectric layer to expose a portion of the doped region;
disposing a contact material on the portion of the doped region;
forming a contact member from the contact material and the portion of the doped region; and
removing a remaining portion of the first dielectric layer and the second dielectric layer.

2. The manufacturing method according to claim 1, wherein the second dielectric layer conforming to the sidewall of the opening has a uniform thickness along the sidewall of the opening.

3. The manufacturing method according to claim 1, wherein the remaining portion of the first dielectric layer and the second dielectric layer has a uniform thickness along the sidewall of the opening.

4. The manufacturing method according to claim 1, wherein the sacrificial member is removed after disposing the first dielectric layer.

5. The manufacturing method according to claim 1, wherein during disposing the contact material on the portion of the doped region, the contact material is disposed on the remaining portion of the first dielectric layer and the second dielectric layer.

6. The manufacturing method according to claim 5, wherein during removing the remaining portion of the first dielectric layer and the second dielectric layer, the contact material on the remaining portion of the first dielectric layer and the second dielectric layer is removed.

7. The manufacturing method according to claim 1, wherein during removing the first portion of the second dielectric layer, a second portion of the second dielectric layer in contact with the first dielectric layer is removed.

8. The manufacturing method according to claim 7, wherein the second portion of the second dielectric layer and the portion of the first dielectric layer are removed simultaneously.

9. The manufacturing method according to claim 1, wherein the contact material is disposed on the portion of the doped region and on the remaining portion of the first dielectric layer and the second dielectric layer.

10. The manufacturing method according to claim 1, wherein the first dielectric layer and the second dielectric layer are disposed by use of thermal oxidation, and the first portion of the second dielectric layer is removed by use of dry etching.

11. The manufacturing method according to claim 1, wherein the contact member comprises silicide, and is formed after rapid thermal processing (RTP) is performed on the contact material and the portion of the doped region.

12. The manufacturing method according to claim 1, further comprising:
forming a barrier layer on the epitaxial layer, the doped region and the contact member; and
forming an electrode on the barrier layer.

13. A power semiconductor structure, comprising:
A substrate;
an epitaxial layer on the substrate;
a groove extending into the epitaxial layer;
a doped region disposed under the groove;
a contact member disposed on the doped region or partially surrounded by the doped region; and
a barrier layer disposed on the epitaxial layer and in the groove,
wherein, a lateral distance between a sidewall of the groove and an outer sidewall of the contact member and around the contact member is uniform.

14. The power semiconductor structure according to claim 13, wherein a width of the groove is equal to twice the lateral distance plus a width of the contact member.

15. The power semiconductor structure according to claim 13, wherein a width of a portion of the barrier layer surrounding the contact member is uniform.

16. The power semiconductor structure according to claim 13, wherein a central axis of the groove is common to a central axis of the contact member.

17. The power semiconductor structure according to claim 13, wherein a width of a portion of the doped region surrounding the contact member is uniform.

18. The power semiconductor structure according to claim 13, wherein the contact member is in ohmic contact with the doped region, and the barrier layer is a Schottky barrier.

19. The power semiconductor structure according to claim 13, further comprising an electrode disposed on the barrier layer.

20. The power semiconductor structure according to claim 19, wherein a current flowing from the electrode to the epitaxial layer through the barrier layer and the contact member is greater than a current flowing from the electrode to the epitaxial layer through the barrier layer.

21. A method for manufacturing a power semiconductor structure, comprising:
forming an epitaxial layer over a substrate;
disposing a patterned mask on the epitaxial layer;
implanting a dopant into the epitaxial layer exposed from the patterned mask to form a doped region of the epitaxial layer;
disposing a sacrificial member to cover the doped region;
disposing a first dielectric layer on the epitaxial layer;
removing the sacrificial member to form an opening surrounded by the first dielectric layer and exposing the doped region;
disposing a second dielectric layer on the first dielectric layer and the doped region, wherein the second dielectric layer is conformal to a sidewall of the opening;
removing a first portion of the second dielectric layer to expose a portion of the doped region;
disposing a contact material on the portion of the doped region;
forming a contact member from the contact material and the portion of the doped region; and
removing a remaining portion of the first dielectric layer and the second dielectric layer.

22. The manufacturing method according to claim 21, wherein the second dielectric layer conformally disposed on the sidewall of the opening has a uniform thickness along the sidewall of the opening.

23. The manufacturing method according to claim 21, wherein the sacrificial member protrudes from the epitaxial layer.

24. The manufacturing method according to claim 21, wherein a second portion of the second dielectric layer is in contact with the first dielectric layer and is removed during removing the first portion of the second dielectric layer.

25. The manufacturing method according to claim 21, further comprising:
forming a barrier layer on the epitaxial layer and the doped region and surrounding the contact member; and
forming an electrode on the barrier layer.

26. A power semiconductor structure, comprising:
A substrate;
an epitaxial layer on the substrate;
a doped region extending into in the epitaxial layer;
a contact member disposed on the doped region or partially surrounded by the doped region; and
a barrier layer disposed on the epitaxial layer and the doped region and surrounding the contact member,
wherein a width of an interface between the doped region and the barrier layer and surrounding the contact member is uniform.

27. The power semiconductor structure according to claim 26, wherein a width of a portion of the doped region surrounding the contact member is uniform.

28. The power semiconductor structure according to claim 26, wherein a width of the doped region is equal to twice a width of the interface plus a width of the contact member.
